(19) **Europäisches Patentamt / European Patent Office / Office européen des brevets**

(11) **EP 1 331 489 B1**

(12) **EUROPÄISCHE PATENTSCHRIFT**

(45) Veröffentlichungstag und Bekanntmachung des Hinweises auf die Patenterteilung:
**29.09.2010 Patentblatt 2010/39**

(51) Int Cl.:
***G01R 33/34*** *(2006.01)*

(21) Anmeldenummer: **03000978.1**

(22) Anmeldetag: **17.01.2003**

(54) **Magnetische Homogenisierung von Supraleitenden HF-Spulen für den Empfang von NMR-Signalen**

Magnetic homogeneisation of superconducting RF coils for the reception of NMR signals

Homogénéisation magnétique de bobines RF pour la réception de signaux RMN

(84) Benannte Vertragsstaaten:
**CH FR GB LI**

(30) Priorität: **29.01.2002 DE 10203279**

(43) Veröffentlichungstag der Anmeldung:
**30.07.2003 Patentblatt 2003/31**

(73) Patentinhaber: **Bruker BioSpin AG**
**8117 Fällanden (CH)**

(72) Erfinder: **Marek, Daniel**
**5103 Mölken (CH)**

(74) Vertreter: **Kohler Schmid Möbus**
**Patentanwälte**
**Ruppmannstraße 27**
**70565 Stuttgart (DE)**

(56) Entgegenhaltungen:
**EP-A- 1 302 780    EP-A- 1 314 994**
**WO-A-99/24845    DE-A- 19 733 574**

EP 1 331 489 B1

## Beschreibung

Die Erfindung betrifft ein Verfahren gemäß dem Oberbegriff von Anspruch 1.

Ein derartiges Verfahren ist aus der WO 99/24845 (Zitat [2]) bekannt.

NMR ist eine sehr aussagekräftige Analysemethode, sie ist jedoch nicht sehr empfindlich. Nach dem Stand der Technik ist es möglich, durch Verwendung von gekühlten, und insbesondere supraleitenden Hochfrequenzspulen das S/N (signal to noise) Verhältnis wesentlich zu steigern. Solche Anordnungen wurden beschrieben in [1]. Das wesentliche Problem der Verwendung von Supraleitern bei NMR Empfangssystemen (HF-Empfangsspule) ist ihre statische Magnetisierung. Diese kann, wenn sie nicht kontrolliert wird, so große Feldstörungen innerhalb der Probe verursachen, dass die Linienbreite unbrauchbar groß wird. Es wurde eine Anzahl von Verfahren publiziert, um diese unerwünschte Magnetisierung zu minimieren: [2], [3], [4]. Die beschriebenen Verfahren sind jedoch kompliziert und weisen weitere Nachteile auf, wie weiter unten erörtert werden. Insbesondere bewirken bei Spulen gemäß [1] später angewandte transversale Magnetfelder eine Erzeugung von wesentlichen Störfeldern.

Es gibt zwei Klassen von Spulenanordnungen, die in [5] und [6] beschrieben wurden, die neben anderen Vorteilen auf diese Störungen immun und darum den oberen Spulentypen [1] auch unter Benutzung der Verfahren [2,3] überlegen sind.

Werden die Spulen gemäss [5] oder [6] trotz ihrer Vorteile jedoch einmal ungleichmäßig magnetisiert, verlieren sie ihre guten Eigenschaften.

Wie in [2] ausführlich dargestellt wird, ergibt sich eine globale Magnetisierung eines Supraleiters vom Typ II durch eingeprägte Ströme, die innerhalb des Supraleiters in geschlossenen Bahnen fließen. Diese werden durch die Vorgeschichte des Supraleiters bestimmt und bleiben, sobald sich die äußeren Verhältnisse nicht ändern, wegen des Null-Widerstandes des Supraleiters, für praktisch unbeschränkte Zeiten bestehen. Diese Ströme erzeugen außerhalb des Supraleiters ein Magnetfeld, das starke unerwünschte Feldstörungen im Probenvolumen erzeugen kann.

Der bisherige Ansatz zur Minimierung von Störungen in den Spektren durch von durch supraleitende HF Spulen verursachte Inhomogenitäten des statischen Magnetfeldes bestand aus den folgenden Strategien:

A. Minimierung der Störungen in den Spektren gemäss Stand der Technik

A1    Minimierung der maximal möglichen Größe der Magnetisierung (durch Unterteilung der Spule in hinreichend schmale Streifen [1], [5]).

A2    Die verbleibende mögliche Magnetisierung erst gar nicht entstehen zu lassen. Bei allen nach dem Stand der Technik bekannten Verfahren wird der Supraleiter stets im Magnetfeld abgekühlt, damit die Magnetfeldlinien in ihrer ungestörten Form beim supraleitenden Übergang des Typ II Supraleiters in diesem eingefroren werden. Somit werden möglichst wenige vom ursprünglichen, homogenen $B_0$ Feldverlauf abweichende Feldlinien erzeugt und somit auch möglichst wenig Störungen der Homogenität des Magnetfeldes. Die Patentschrift [4] empfiehlt sogar, diesen Abkühlprozess möglichst langsam durchzuführen, damit das $B_0$ Feld möglichst gleichmäßig und somit störungsfrei eingefroren wird.

A3    Durch Nachbehandlung der supraleitenden Spule mit einer Sequenz abnehmender transversaler Magnetfelder sozusagen zu "Entmagnetisieren" [2], [3] (dabei wird eine Stromstruktur mit eng beieinanderliegenden entgegengesetzten Strombereichen eingeprägt, sodass die Summe der einzelnen Magnetfeldbeiträge sich in guter Näherung aufheben soll).

Allen bisher bekannten Verfahren liegt die gemeinsame Bestrebung zugrunde, die effektive magnetische Suszeptibilität und somit die Magnetisierung der supraleitende Spule(n) und damit die externen durch die supraleitende Spule(n) erzeugten Magnetfelder zu **minimieren** oder vollkommen zu **eliminieren**, und damit auch die in der Probe erzeugten Magnetfelder zu minimieren.

Das letztendliche Ziel aller hier diskutierten Verfahren und Vorrichtungen ist es aber eigentlich, die durch die supraleitenden (SL) Spulen erzeugten NMR Störungen in den Spektren zu eliminieren. Wie wir jedoch sehen werden, ist dies nicht notwendigerweise gleichbedeutend mit der Minimierung oder Eliminierung der effektiven Suszeptibilität oder Minimierung/ Eliminierung der durch die SL Spulen erzeugten Zusatzfelder! Dieser feine, aber sehr wesentliche Unterschied in der Zielsetzung wurde im Stand der Technik [2], [3], [4] bisher völlig übersehen, und alle bisherigen Ansätze konzentrierten sich demzufolge auf die Eliminierung bzw. Reduktion aller durch die SL Spulen erzeugten Zusatzfelder. Realisiert man aber diesen Unterschied präzise, werden plötzlich ganz andersartige Lösungen der Aufgabenstellung, nämlich die Eliminierung oder signifikante Reduktion der NMR Störungen in den Spektren, möglich.

Aufgabe der vorliegenden Erfindung ist es somit, Hochfrequenzspulen mit homogener transversaler Sättigungsmagnetisierung, also Spulen gemäss [5] und eine Teilmenge der Spulen gemäss [6], aus einem beliebigen Magnetisierungszustand in einen Zustand zu bringen, bei dem die NMR-relevanten Feldstörungen praktisch eliminiert sind.

Erfindungsgemäß wird diese Aufgabe durch das in Anspruch 1 definiert Verfahren gelöst.

Viele der Spulen, bei denen der Supraleiter über den HF Bereich hinaus hinreichend ausgedehnt sind ([5],[6]), können mittels der vorliegenden Erfindung einfach und rasch von magnetischen Störungen befreit werden:

Ganz im Gegensatz zu den Verfahren [2], [3], [4] nach dem Stand der Technik erreicht die vorliegende Erfindung die Eliminierung der NMR Störungen durch eine Homogenisierung, in der einfachsten Form sogar durch eine **Maximierung** der Magnetisierung des Supraleiters, sowie mit einer damit einhergehenden **Maximierung** der magnetischen Störfelder in der Probe. Dieser Tatbestand ist auf den ersten Blick völlig widersinnig und mit den bekannten Verfahren nicht vereinbar. Wie jedoch weiter unten beschrieben wird, führt dies bei der betrachteten Spulenklasse zum gewünschten Erfolg. Dazu kommt noch, dass das erfindungsgemäße Verfahren im Gegensatz zu den Verfahren gemäss Stand der Technik sehr einfach durchzuführen ist, eine einfache oder gar keine Hardware benötigt und zudem sehr robuste und reproduzierbare Ergebnisse erzielt.

Wir wollen in der Folge das Wesen der vorliegenden Erfindung erklären.

B. Erfindungsgemäßes Verfahren:

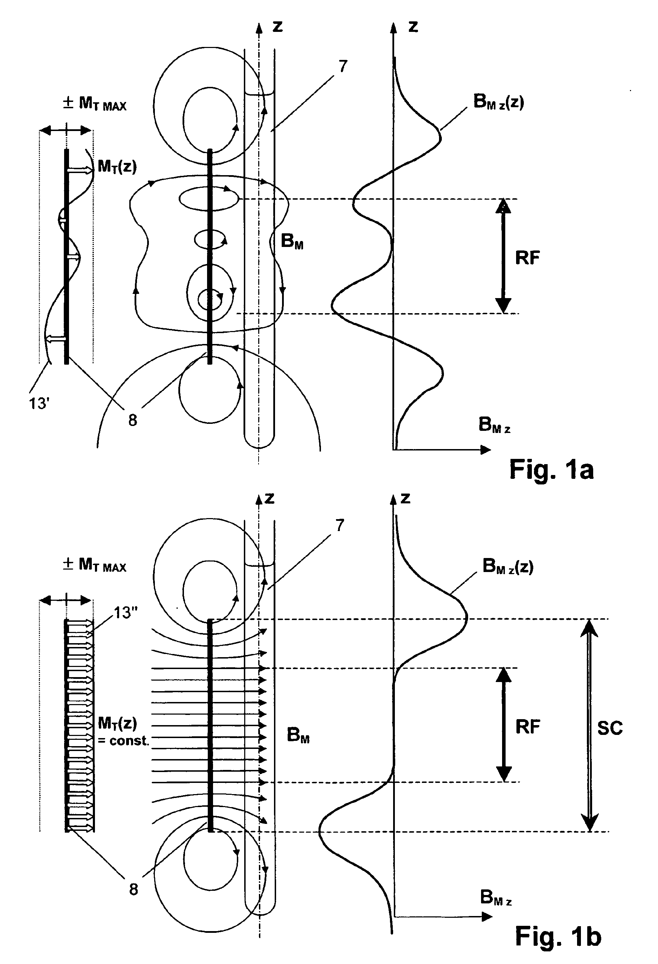

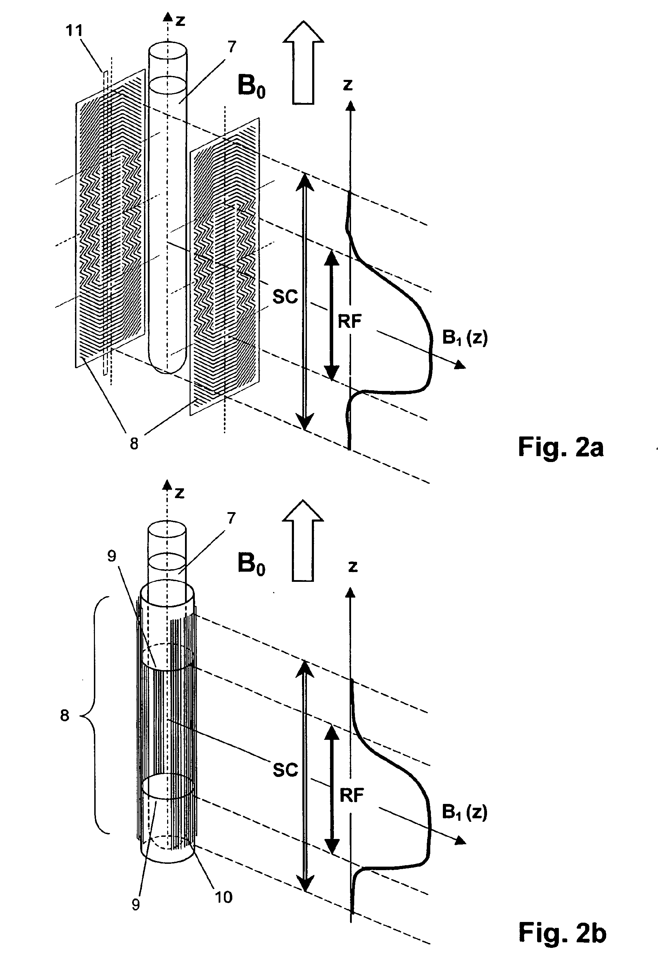

B1 Wir bezeichnen die Spulen gemäss [6], bei denen die kritischen Ströme der Supraleiter isotrop sind oder bei denen die Ausführungsformen 3 oder 4 von [6] verwendet werden, oder aber Birdcage-Spulen gemäss Anordnungen wie in ([5], Fig. 1), sogenannte "Spulen mit homogener transversaler Sättigungsmagnetisierung", hier genannt **"CHTSM" (Coils with Homogeneous Transverse Saturation Magnetisation)**. Solche Spulenanordnungen 8 sind in **Fig. 2** dargestellt, zusammen mit dem Probenröhrchen 7.

Wie in [6] dargestellt wurde, ist es für die Shimbarkeit nicht wesentlich, dass alle Feldkomponenten eines durch die SL Spulen erzeugten und in der Probe auftretenden zusätzlichen Störfelder dB klein werden, sondern es muss NUR die $B_z$ Komponente minimiert oder zumindest homogen gehalten werden. Die in [6] beschriebenen Spulen machen sich diese Erkenntnis zugrunde. Sie erzeugen als Reaktion auf externe Querfelder eine entlang $B_0$ homogene transversale Magnetisierungsdichte. Diese führt, unabhängig von der Größe der transversalen Magnetisierung, zu einer vernachlässigbaren $B_z$ Komponente am Probenort. Wesentlich ist aber dabei, dass die transversale Magnetisierungsdichte konstant über z ist.

B2 Bei den CHTSM Spulen ergibt sich nun die erfindungsgemäße Möglichkeit, die notwendige z-Homogenität der transversalen Magnetisierung zu erreichen ohne die Verfahren gemäss A2 oder A3 zu gebrauchen. Es ist ganz wesentlich zu realisieren, dass die Konstanz der Magnetisierung über z, und nicht die absolute Größe der Magnetisierung, wesentlich ist. Gelingt es, die Konstanz zu erzielen, ist das Ziel erreicht. Bei den CHTSM Spulen wird dies erfindungsgemäß erreicht, indem die dieser Spulenklasse inhärente Konstanz (in z) der maximalen (Sättigungs-) Magnetisierung verwendet wird.

B3 Es ist möglich, nach einem beliebigen Magnetisierungszustand (der i.A. keine gleichmäßige Magnetisierung in z aufweist, ein solcher ist in **Fig. 1a** dargestellt), die transversale Magnetisierung in z homogen zu machen, indem alle Teilstrukturen nicht minimal, sondern homogen, insbesondere maximal magnetisiert werden. Dies führt auch zu einer Maximierung der Störfelder dB am Probenort. Diese sind i.A. nicht homogen (starke Inhomogenitäten in der x,y Ebene) und können sehr stark sein. Dies ist in **Fig. 1b** dargestellt.

B4 Diese maximale Magnetisierung des SL ist durch die Geometrie (Breite, Dicke) der einzelnen Elemente und durch die kritische Stromdichte des Supraleiters entlang der längsten Dimension der Elemente gegeben.

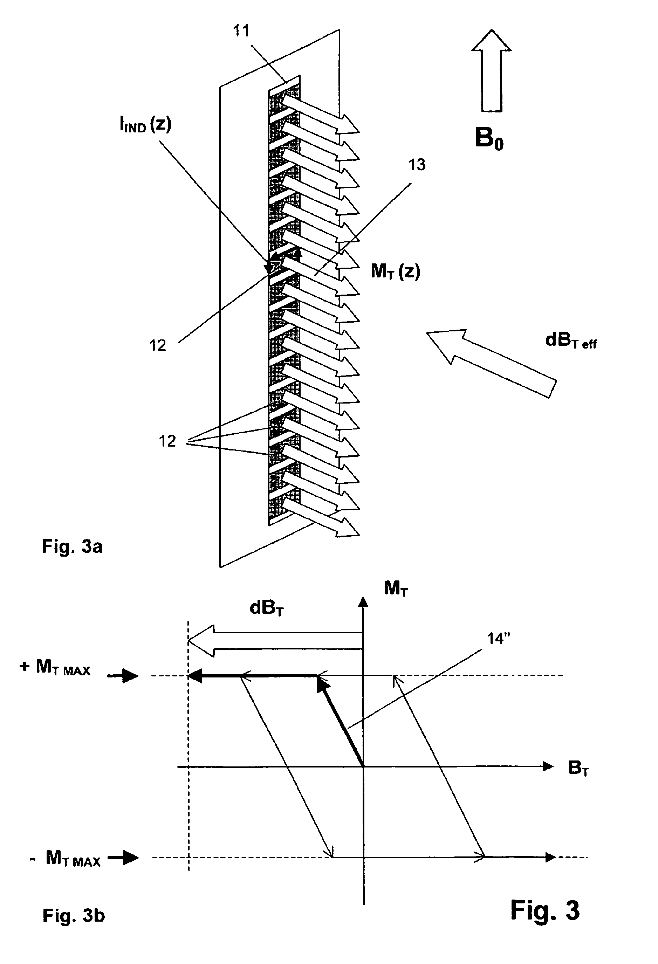

B5 Dadurch werden bei entsprechend ausgeführten Spulen (CHTSM-Spulen, Punkt B1 oben) eine zwar große (maximal starke), aber sehr genau definierte, und entlang z gleichmäßige transversale Magnetisierung $M_T$ wie in Fig. 3 sichtbar, erzielt.

B6 Diese führt nun gemäss [6] zu einem Verschwinden der NMR-relevanten Störungen! Dies ist in **Fig. 1b** gezeigt.

B7 Diese Störungsfreiheit bleibt dann gemäss [6] auch für alle späteren Zeiten erhalten, sofern nicht zu starke inhomogene transversale Magnetfelder angewendet werden.

Wie also oben dargelegt wurde, genügt für die CHTMS Spulentypen ein einziger sehr starker magnetischer Puls oder die Anwendung eines starken transversalen Magnetfeldes, um die relevanten NMR Störungen zu eliminieren. Dies hat gegenüber den Verfahren [2,3] gemäss Stand der Technik die folgenden Vorteile:

### C. Vorteile:

C1   Ein einziger Puls genügt, es sind keine komplizierten Pulsformen und Sequenzen nötig.

C2   Die Stärke des Pulses muss nur genügend groß sein, es sind keine genauen Anpassungen an das verwendete SL Material erforderlich.

C3   Diese Sättigung kann demzufolge sehr schnell durchgeführt werden, da keine abnehmenden Sequenzen wie in [2,3] erforderlich sind.

C4   Es sind keine präzisen Vorrichtungen notwendig

C5   Dank der obigen Punkte kann die magnetische Behandlung, falls gewünscht, auch vor/während/zwischen Pulssequenzen durchgeführt werden.

C6   Das Verfahren braucht im einfachsten Fall gar keine zusätzliche Vorrichtungen.

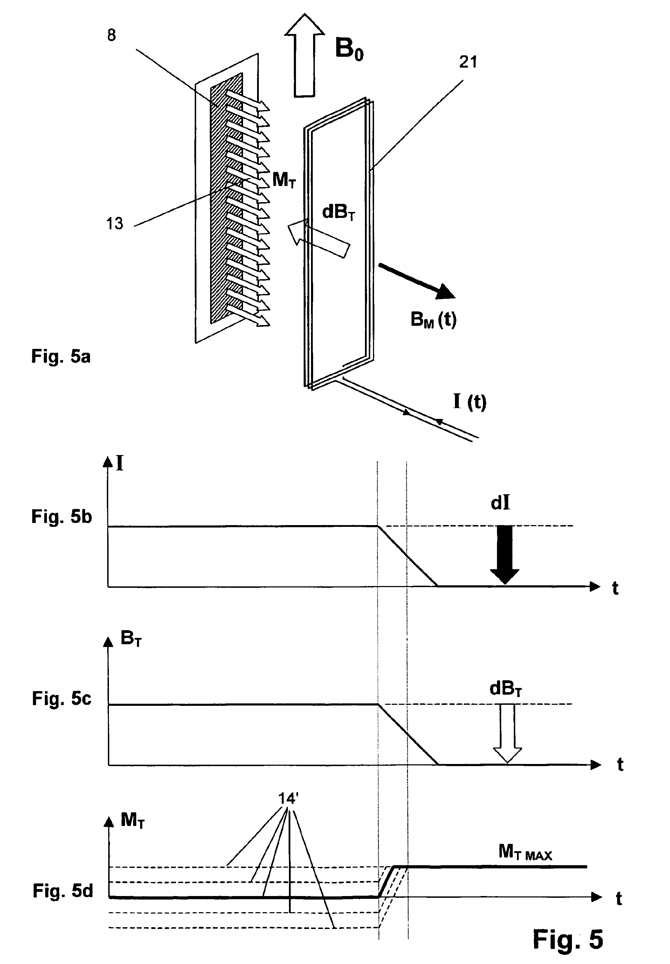

Das Verfahren kann in einer einfachen Ausführungsform durch eine transversale Feldspule 21 (**Fig. 5**) erreicht werden. In dieser Figur ist das Magnetisierungsfeld $B_T$ dargestellt. Wichtig ist, dass eine hinreichend große Änderung $dB_T$ stattfindet. Dies kann auf verschiedene Weisen, im einfachsten Falle aber durch ein Ausschalten des zuvor eingeschalteten Stromes I geschehen (Fig. 5b, 5c). Unabhängig von der anfänglichen Magnetisierung (Durchgezogene oder gestrichelte Linien in Fig. 5d) geht nun die transversale Magnetisierung $M_T$ gegen einen maximalen, wohl definierten, entlang z konstanten Wert $M_{T\,MAX}$. Damit gehen auch die im Sample 7 erzeugten Magnetfelder $B_M$ gegen einen maximalen, aber entlang z konstanten Wert.

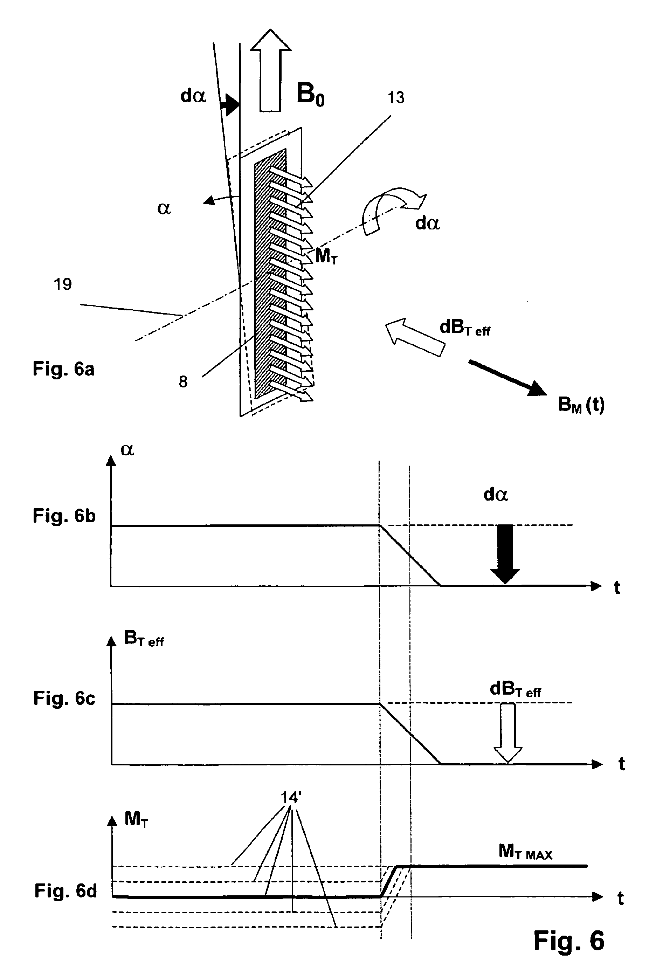

Wegen Punkten C1, C2, C4 kann die Implementierung aber auch durch ein mechanisches Verkippen der supraleitenden Spulenanordnung sehr einfach ausgeführt werden, eine einzige Bewegung oder eine einzige Hin- und Herbewegung mit einem Anschlag genügt bereits. Es ist keinerlei Kontrolle der Amplitude notwendig (es muss nur sichergestellt sein, dass eine minimale Amplitude erreicht wird). Dies ist in der einfachsten Form in Fig. 6 dargestellt. Das Resultat ist <u>unabhängig</u> vom Anfangs-Magnetisierungszustand (verschiedene gestrichelte Linien in Fig. 6d, sie alle führen zu $M_T$ max.)

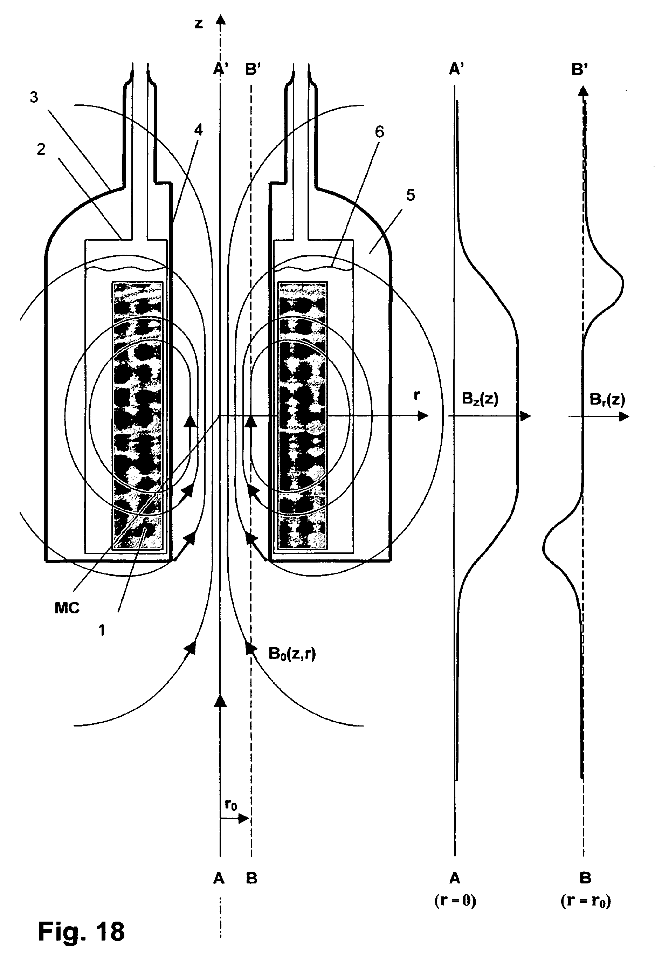

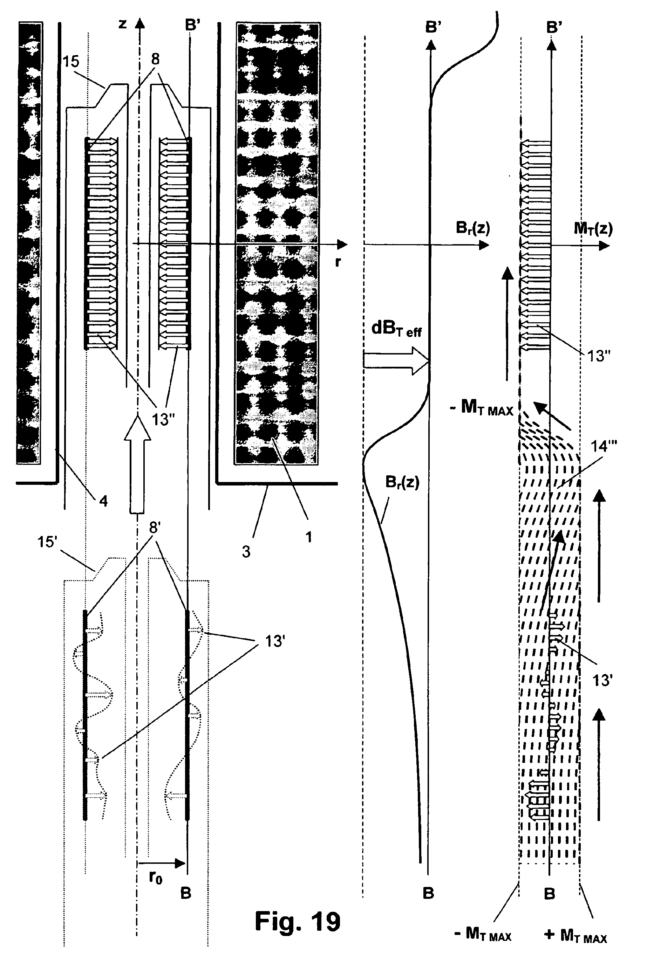

Die gleiche Argumentation wie bei Punkt B5 oben erlaubt auch eine ganz einfache Implementierung des Verfahrens, indem gar keine spezielle Vorrichtung gebraucht wird: Der Messkopf wird einfach im kalten Zustand (Supraleitende (SL) Spulen unterhalb der kritischen Temperatur Tc) aus dem Magneten (hinreichend weit) herausgezogen und wieder eingeführt. Dies hat zur Folge, dass die radialen $B_0$ Komponenten (die außerhalb des homogenen Bereichs ("Plateau") des Magneten vorhanden sind, wegen der Krümmung der Feldlinien nach außen, siehe **Fig. 18**) beim Einführen automatisch die SL-Spule einer schlussendlich monoton zunehmenden, sehr starken transversalen Feldänderung $dB_{T\,eff}$ (Fig.19) aussetzen. (Oder der Kopf wird, ganz im Gegensatz zu [4] erst außerhalb des Magneten unter Tc abgekühlt und dann kalt eingeführt.)

Der Verlauf von $M_T(z)$ sowie die Bewegung der SL Spule beim Einführen in den Magneten ist in **Fig. 19** dargestellt. Dieses Verfahren hat übrigens wegen der Rotationssymmetrie um z den Vorteil, dass nicht nur planare Strukturen in einer Ausrichtung (z.B. parallel zu x) gesättigt werden, sondern auch die senkrecht orientierten (parallel zu y) oder auch in jeder anderen Orientierung gleichermaßen gut gesättigt werden.

Wie nun dargelegt wurde, bildet das Verfahren eine völlig neue, sehr effektive, robuste und billige Art, supraleitende NMR Spulen so zu konditionieren, dass sie keine Störungen im NMR Spektrum hervorrufen. Diese Verfahren und Vorrichtungen bilden, zusammen mit den CHTSM Spulen, einen wichtigen Baustein zur breiten Anwendung der SL Technologie bei NMR Empfangsspulen.

Eine bevorzugte Variante des erfindungsgemäßen Verfahrens ist dadurch gekennzeichnet, dass das transversal zu den planaren Elementen gerichtete Magnetfeld in seinem zeitlichen Verlauf so gewählt wird, dass die supraleitenden Komponenten auch nach Anwendung dieses Magnetfeldes maximal magnetisiert bleiben und dadurch das durch sie verursachte, bezüglich $B_0$ transversale Magnetfeld im Probenbereich maximiert wird. Dieser Endzustand der HF-Spulenmagnetisierung ist besonders einfach herzustellen, insbesondere durch einen einzigen magnetischen Impuls.

Bei einer besonders bevorzugten Verfahrensvariante wird das transversal zu den planaren Elementen gerichtete Magnetfeld transversal zum statischen Magnetfeld $B_0$ angelegt. Dies ist die einfachste Geometrie zur Erzielung der erfindungsgemäßen transversalen Magnetisierung der supraleitenden Strukturen, bei der das gesamte zusätzliche Magnetfeld zur transversalen Magnetisierung beiträgt.

Obige Verfahrensvariante kann bevorzugt besonders einfach dadurch realisiert werden, dass das auf die supraleitenden Komponenten wirkende, transversal zu den planaren Elementen gerichtete Magnetfeld durch eine Verkippung der planaren Elemente um eine nicht zur Richtung von $B_0$ parallele Achse erzeugt wird. Dadurch wird das statische Magnetfeld $B_0$ zur Magnetisierung genutzt, so dass zusätzliche felderzeugende Strukturen nicht erforderlich sind.

Andererseits ist es in einer Verfahrensvariante auch möglich, das transversal zu den planaren Elementen gerichtete Magnetfeld durch eine Feldspule zu erzeugen. Dies ermöglicht eine genau definierte Einbringung des zusätzlichen Magnetfelds, etwa als Abfolge von magnetischen Impulsen.

Bei einer weiteren, bevorzugten Verfahrensvariante wird das transversal zu den planaren Elementen gerichtete Magnetfeld durch zwei oder mehrere Feldspulen für vershiedene Feldrichtungen erzeugt, die nacheinander so aktiviert werden, dass die supraleitenden Komponenten der HF-Spulen im Verlauf der Behandlung mindestens einmal maximal magnetisiert werden. Dadurch wird eine homogene Magnetisierung der supraleitenden Komponenten auch dann gewährleistet, wenn die supraleitenden Komponenten räumlich verteilt ausgerichtet sind.

Eine andere, bevorzugte Verfahrensvariante ist dadurch gekennzeichnet, dass das auf die supraleitenden Komponenten wirkende, transversal zu den planaren Elementen gerichtete Magnetfeld durch eine sukzessive Verkippung der planaren Elemente um zwei nicht zur Richtung von $B_0$ und auch nicht zueinander parallele Achsen erzeugt wird. Auch dadurch wird eine homogene Magnetisierung der supraleitenden Komponenten gewährleistet, wenn diese räumlich verteilt ausgerichtet sind. Insbesondere erfordert diese Variante keine zusätzlichen, magnetfelderzeugenden Strukturen.

Eine besonders bevorzugte Verfahrensvariante sieht vor, dass das transversal zu den planaren Elementen gerichtete Magnetfeld durch ein erstmaliges oder abermaliges Einführen der bereits supraleitenden HF-Spulen in den Magneten, der das statische Magnetfeld $B_0$ erzeugt, erzeugt wird. Dies ist besonders einfach und kostengünstig.

In einer weiteren Verfahrensvariante erfolgt die Anwerdung des transversal zu den planaren Elementen gerichteten Magnetfelds mit nur einem Vorzeichen. Dadurch wird eine unerwünschte Entmagnetisierung der supraleitfähigen Komponenten ausgeschlossen.

Eine bevorzugte Verfahrensvariante sieht vor, dass das transversal zu den planaren Elementen gerichtete Magnetfeld ein einzelner Impuls ist. Die Einbringung eines einzelnen Impulses ist eine Magnetisierungsmethode mit geringem apparativem Aufwand.

In einer anderen Verfahrensvariante ist das transversal zu den planaren Elementen gerichtete Magnetfeld ein Doppel- oder Mehrfachpuls, bei dem der letzte Puls eine solche Amplitude und ein solches Vorzeichen besitzt, dass die endgültige, bezüglich $B_0$ transversale Magnetisierung der supraleitenden Komponenten ungleich Null ist. Diese Variante kann dazu eingesetzt werden, eine bestimmte, von Null verschiedene transversale Magnetisierung einzustellen und gleichzeitig weitere Störungen, die sich aus der Anwendung der Pulse ergeben, zu minimieren.

Eine weitere Verfahrensvariante sieht vor, dass das transversal zu den planaren Elementen gerichtete Magnetfeld ein Doppelpuls ist, bei dem der zweite Puls das umgekehrte Vorzeichen des ersten Pulses hat und die Amplituden beider Pulse ungefähr gleich groß sind. Dadurch wird die vom ersten Impuls erzeugte Magnetisierung durch den zweiten Puls invertiert. Ein Doppelpuls hat die günstige Eigenschaft, dass allfällige Wirbelströme in den benachbarten Strukturen minimiert werden.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1a: Das durch die supraleitenden Komponenten eines Elements der NMR-Empfangsspulenanordnung verursachte Störfeld $B_{Mz}$ vor der Anwendung des erfindungsgemäßen Verfahrens;

Fig. 1b: Das durch die supraleitenden Komponenten eines Elements der NMR Empfangsspulenanordnung verursachte Störfeld $B_{Mz}$ nach der Anwendung des erfindungsgemäßen Verfahrens;

Fig. 2a: Eine NMR-Empfangsspulenanordnung nach Referenz [6], auf die sich das erfindungsgemäße Verfahren bezieht;

Fig. 2b: Eine NMR-Empfangsspulenanordnung nach Referenz [5], auf die sich das erfindungsgemäße Verfahren bezieht;

Fig. 3a: Die schematische Darstellung des Magnetisierungszustands eines streifenförmigen Teilstücks einer erfindungsgemäß magnetisierten HF-Spule;

Fig. 3b: Die zugehörige schematische Analyse der magnetischen Reaktion eines Flächenelements der supraleitenden NMR-Empfangsspulenanordnung auf eine äußere Feldänderung;

Fig. 4a: Den zeitlichen Verlauf eines einfach stufigen transversalen Magnetfelds im B-t-Diagramm;

Fig. 4b: Den zugehörigen zeitlichen Verlauf der Spulenmagnetisierung im M-t-Diagramm;

Fig. 4c: Die zugehörige schematische Analyse der Beziehung zwischen dem äußeren Magnetfeld und der Magnetisierung eines supraleitenden Elements;

Fig. 5a: Die schematische Darstellung des Magnetisierungszustands eines streifenförmigen Teilstücks einer HF-Spule, die erfindungsgemäß mit einer Feldspule magnetisiert wurde;

Fig. 5b: Den zugehörigen zeitlichen Verlauf des Feldspulenstroms im I-t-Diagramm;

Fig. 5c: Den zugehörigen zeitlichen Verlauf des transversalen Magnetfelds im B-t-Diagramm;

Fig. 5d: Den zugehörigen zeitlichen Verlauf der Spulenmagnetisierung im M-t-Diagramm;

Fig. 6a: Die schematische Darstellung des Magnetisierungszustands eines streifenförmigen Teilstücks einer HF-Spule, der erfindungsgemäß durch Verkippung des Empfangsspulenelements im statischen Magnetfeld $B_0$ erzeugt wurde;

Fig. 6b: Den zugehörigen zeitlichen Verlauf der Verkippung im $\alpha$-t-Diagramm;

Fig. 6c: Den zugehörigen zeitlichen Verlauf des effektiven transversalen Magnetfelds im B-t-Diagramm;

Fig. 6d: Den zugehörigen zeitlichen Verlauf der Spulenmagnetisierung im M-t-Diagramm;

Fig. 7a: Den zeitlichen Verlauf verschiedener einfach gestufter äußerer Magnetfeldänderungen im B-t-Diagramm;

Fig. 7b: Den zugehörigen zeitlichen Verlauf der Spulenmagnetisierung im M-t-Diagramm;

Fig. 8a: Den zeitlichen Verlauf verschiedener einfach gestufter äußerer Magnetfeldänderungen im B-t-Diagramm, wobei das Vorzeichen der Magnetfeldänderungen gegenüber Fig. 7a invertiert ist;

Fig. 8b: Den zugehörigen zeitlichen Verlauf der Spulenmagnetisierung im M-t-Diagramm;

Fig. 9a: Den zeitlichen Verlauf einer pulsförmigen, äußeren Magnetfeldänderung im B-t-Diagramm;

Fig. 9b: Den zugehörigen zeitlichen Verlauf der Spulenmagnetisierung im M-t-Diagramm;

Fig. 10a: Den zeitlichen Verlauf einer pulsförmigen, äußeren Magnetfeldänderung im B-t-Diagramm, wobei das Vorzeichen der Magnetfeldänderung gegenüber Fig. 9a invertiert ist;

Fig. 10b: Den zugehörigen zeitlichen Verlauf der Spulenmagnetisierung im M-t-Diagramm;

Fig. 11a: Den zeitlichen Verlauf einer doppelpulsförmigen äußeren Magnetfeldänderung im B-t-Diagramm, wobei die beiden Pulse ein unterschiedliches Vorzeichen tragen;

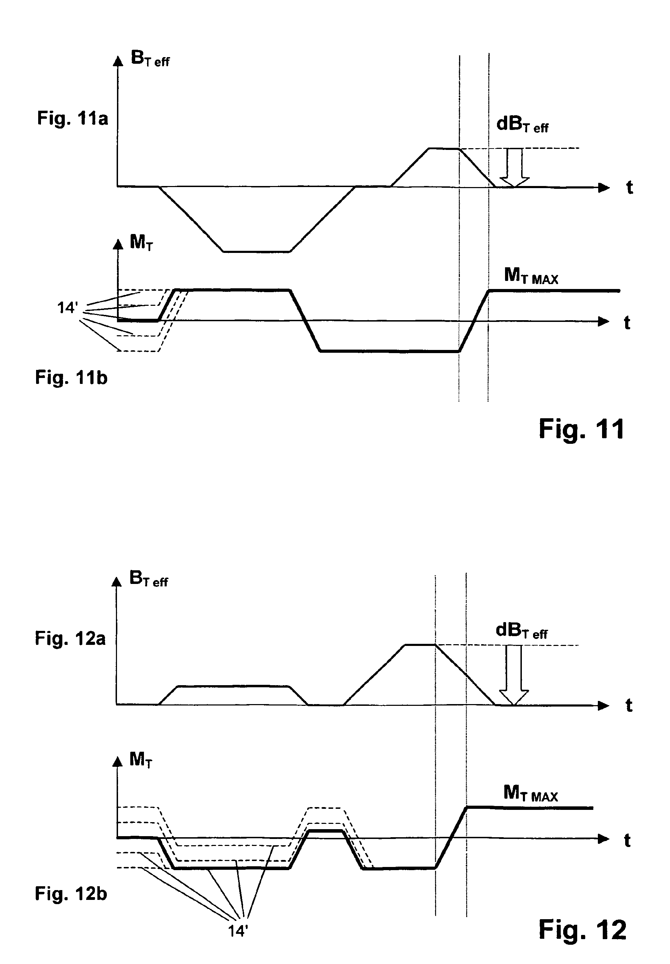

Fig. 11 b: Den zugehörigen zeitlichen Verlauf der Spulenmagnetisierung im M-t-Diagramm;

Fig. 12a: Den zeitlichen Verlauf einer doppelpulsförmigen äußeren Magnetfeldänderung im B-t-Diagramm, wobei die beiden Pulse ein gleiches Vorzeichen tragen;

Fig. 12b: Den zugehörigen zeitlichen Verlauf der Spulenmagnetisierung im M-t-Diagramm;

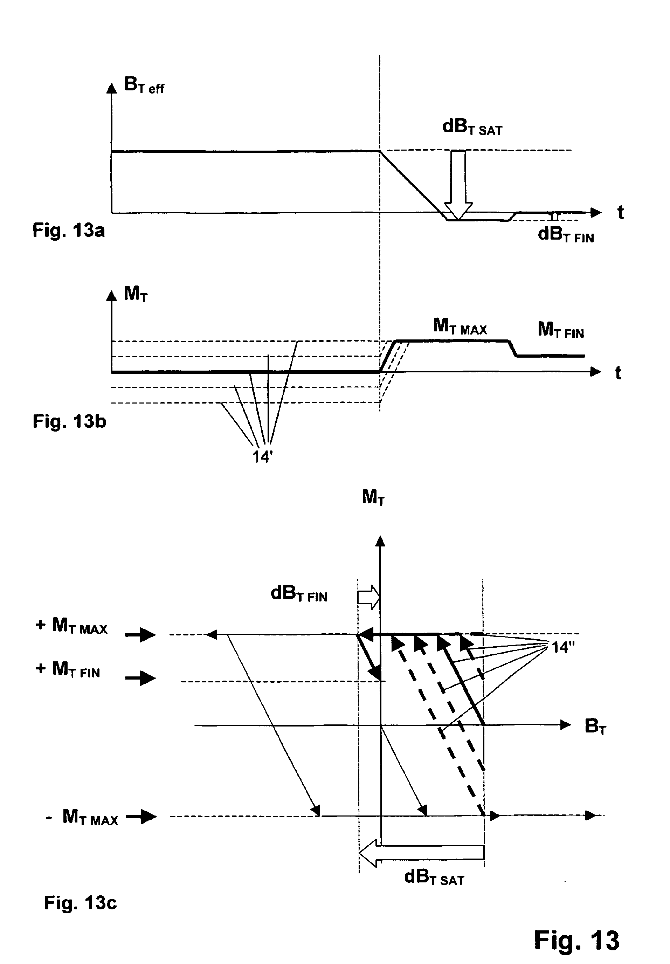

Fig. 13a: Den zeitlichen Verlauf einer stufigen äußeren Magnetfeldänderung im B-t-Diagramm, wobei nach einem Sättigungspuls eine weitere, geringe, entgegengesetzte Feldänderung erfolgt;

Fig. 13b: Den zugehörigen zeitlichen Verlauf der Spulenmagnetisierung im M-t-Diagramm;

Fig. 13c: Die zugehörige schematische Analyse der Beziehung zwischen dem äußeren Magnetfeld und der Magnetisierung eines supraleitenden Elements;

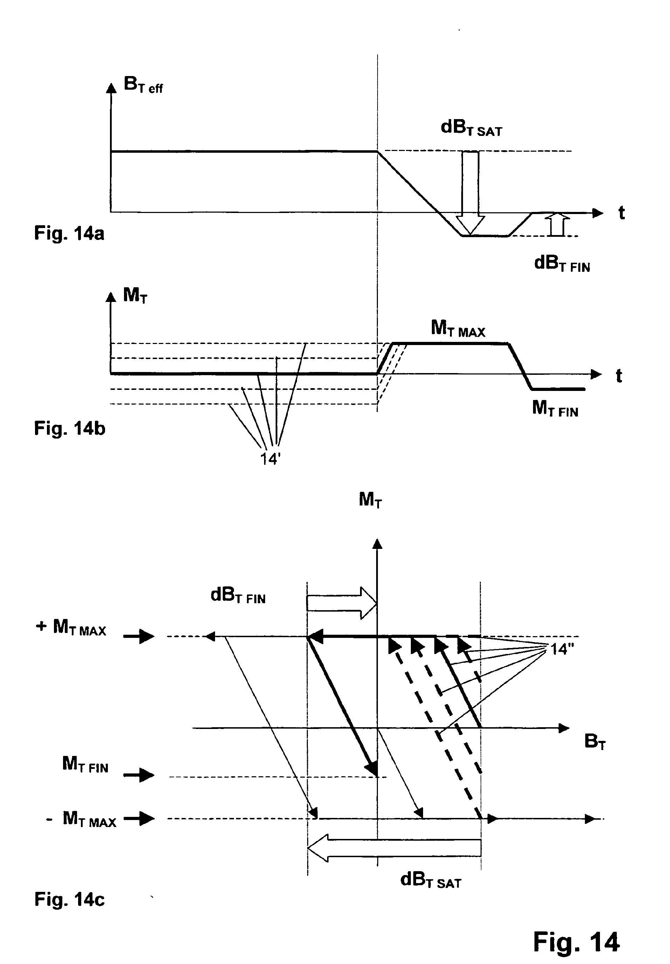

Fig. 14a: Den zeitlichen Verlauf einer stufigen äußeren Magnetfeldänderung im B-t-Diagramm, wobei nach einem Sättigungspuls eine weitere, entgegengesetzte Feldänderung angewandt wird, die die Magnetisierung umkehrt;

Fig. 14b: Den zugehörigen zeitlichen Verlauf der Spulenmagnetisierung im M-t-Diagramm;

Fig. 14c: Die zugehörige schematische Analyse der Beziehung zwischen dem äußeren Magnetfeld und der Magnetisierung eines supraleitenden Elements;

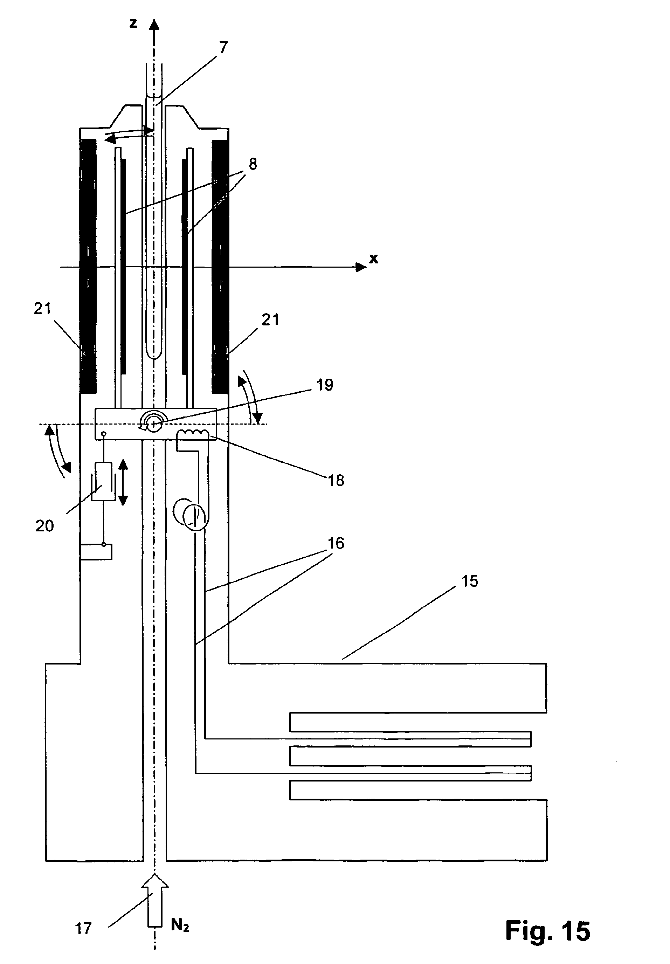

Fig. 15: Ein NMR-Probenkopf, der zur Durchführung des erfindungsgemäßen Verfahrens benutzt werden kann und mit Vorrichtungen zur Erzeugung von $B_T$-Komponenten in x-Richtung ausgestattet ist;

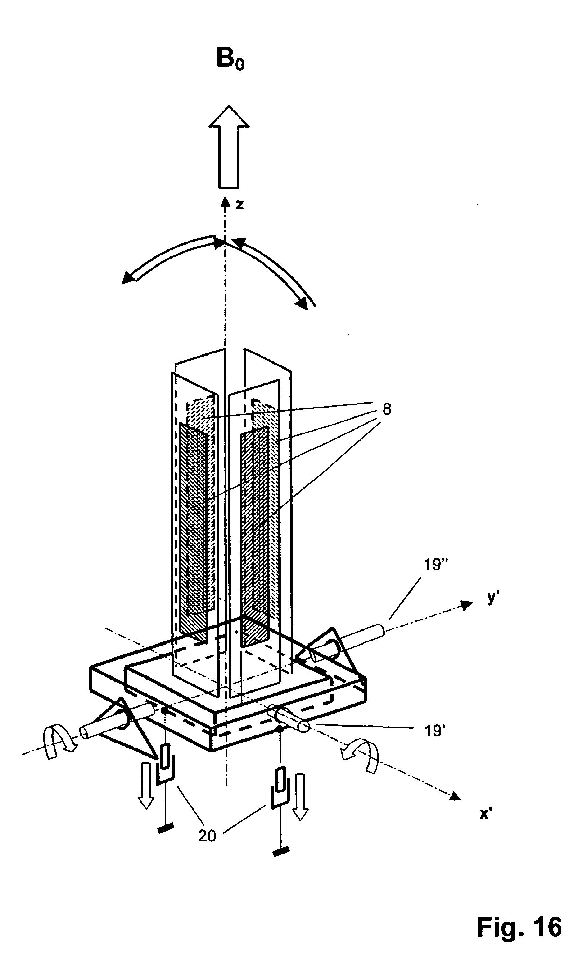

Fig. 16: Ein Ausführungsdetail einer Kippvorrichtung für eine Empfangsspulenanordnung, die zur Anwendung effektiver transversaler Felder in zwei Richtungen geeignet ist;

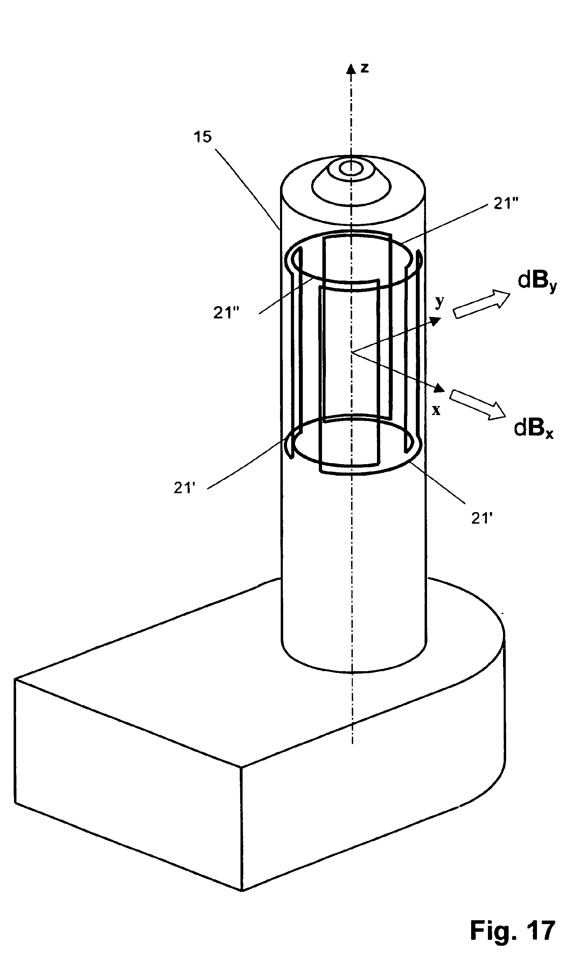

Fig. 17: Eine schematische Anordnung von zwei Feldspulenpaaren, die zur erfindungsgemäßen Anwendung transversaler Felder in zwei Richtungen geeignet ist;

Fig. 18: Schematische Darstellung der Magnetfeldlinien des statischen Magnetfeldes $B_0$ eines supraleitenden Magneten;

Fig. 19: Schematische Darstellung des erfindungsgemäßen Verfahrens, das den Verlauf des transversalen statischen Magnetfeldes beim Ein- oder Wiedereinführen des Probenkopfes mit den bereits supraleitenden Spulenelemente in den Magneten ausnutzt.

Das erfindungsgemäße Verfahren ist nicht auf alle supraleitenden Spulen anwendbar, sondern nur auf solche, die der **"CHTSM"** (**C**oils with **H**omogeneous **T**ransverse **S**aturation **M**agnetisation) Spulenklasse angehören. Diese sind dadurch ausgezeichnet, dass erstens ihre supraleitenden Strukturen parallel zum statischen Feld $B_0$ (welches als parallel zur z-Achse angenommen wird) ausgerichtet sind, zweitens die maximal mögliche (Sättigungs-) Magnetisierung $M_T$, die sich beim Anlegen eines effektiven transversalen Magnetfeldes $B_{T\,eff}$ ergibt, innerhalb jedes makroskopischen, reellen oder gedanklichen Streifens 11 (in Fig. 2a) ergibt, homogen über z ist (eine solche Situation ist in Fig. 3a dargestellt), und drittens weisen diese Spulentypen nur solche supraleitenden Strukturen auf, die den HF Bereich der Spule in z-Richtung hinreichend weit überragen (Fig. 1).

Zwei Vertreter solcher Spulenanordnungen 8 sind in **Fig. 2** dargestellt, zusammen mit dem die NMR Probe enthaltenden Probenröhrchen 7. Es handelt sich einerseits (**Fig. 2a**) um eine Spule gemäss [6], deren supraleitende Strukturen 8 in einer gleichmäßigen Weise über den HF Bereich ("RF") hinaus verlängert sind (bis zur totalen Länge, die durch "SC" bezeichnet ist).

In **Fig. 2b** ist eine Hybrid-Birdcage Spule gemäss [5] dargestellt. Auch sie weist eine gesamte Länge der streifenförmigen, supraleitenden Elemente 10 ("SC") auf, die länger als der HF Bereich ("RF") ist. Bei diesem Spulentyp wird die Beschränkung des HF Bereichs durch normalleitende Elemente 9 erzielt, die einen integralen Teil des Resonators bilden.

Um das erfindungsgemäße Verfahren anwenden zu können, müssen die Spulen derart ausgestaltet sein, dass ihre transversale Sättigungsmagnetisierung entlang jedes gedanklichen in z-Richtung verlaufenden Streifengebiets 11 makroskopisch konstant ist. Dies ist bei der Spule gemäss Fig. 2b normalerweise von selbst gegeben, währenddem bei der Spule gemäss Fig. 2a dies eine in [6] beschriebene Unterklasse von Spulen bildet.

Nun zur Erzeugung der Magnetisierung: Dies wird in **Fig. 3** dargestellt als die magnetische Reaktion eines Flächenelements der supraleitenden NMR Empfangsspulenanordnung auf eine äußere Feldänderung.

Bei dem in **Fig. 3a** dargestellten länglichen Element 11 handelt es sich nicht zwingend um die gesamte Spule, sondern um jedes gedanklich herausgeschnittene, entlang z streifendförmige, makroskopische Teilstück. Es soll nun, unabhängig von der inneren Struktur, die transversale Magnetisierung dieses Teilstückes untersucht werden. Das Streifenelement ist entweder tatsächlich (wie bei der Spule gemäss Fig. 2a) oder nur gedanklich (wie bei der Spule gemäss Fig. 2b) in kleine Flächenelemente 12 unterteilt.

Bei einem Typ II Supraleiter kann die Magnetisierung als Folge von im Supraleiter fließenden Ringströmen interpretiert werden. Diese Ströme I entstehen i.A. als Reaktion auf äußere Feldänderungen. Da der Supraleiter den magnetischen Fluss zu erhalten sucht, werden bei einer äußerlich angewendeten effektiven Feldänderung $dB_{T\,eff}$ Abschirmströme $I_{IND}$ erzeugt, die eine Magnetisierung $M_T$ zur Folge haben, die entgegengesetzt ist zur Änderung $dB_T$ des äußeren Feldes.

Da die im Supraleiter fließenden Ströme durch die maximalen kritischen Stromdichten im Betrag begrenzt sind, ist auch die Magnetisierung im Betrag begrenzt. Eine vereinfachte Beziehung zwischen dem äußeren Magnetfeld $B_T$ und der Magnetisierung $M_T$ ist in **Fig. 3b** dargestellt. Es gilt $-M_{T\,MAX} \leq M_T \leq +M_{T\,MAX}$. Wird aus unmagnetisiertem Zustand ausgegangen, so steigt bei zunehmend negativer werdendem $B_T$ die Magnetisierung bis zum maximalen Wert $+B_{T\,MAX}$ an. Bei einer weiterer Verringerung von $B_T$ bleibt die Magnetisierung auf ihrem maximalen Wert (Fett dargestellt). Die Kurve ist hysteretisch. Bei einer Umkehrung der Änderung von $B_T$ wird der globale Strom $I_{IND}$ kleiner, wechselt schließlich das Vorzeichen, um schließlich beim maximalen Wert eine Magnetisierung von $-M_{T\,MAX}$ zu ergeben. Details dieses Verhaltens sind in [6] und [2-3] ausführlich dargestellt. Wichtig in diesem Zusammenhang ist nun, dass die Ringströme $I_{IND}$ im Prinzip von der Position im Streifenelement 11 abhängen können, i.A. also voneinander unterschiedlich große $I_{IND}(z)$ auftreten können. Somit wird im Prinzip auch $M_T$ von z abhängig. Es gilt also stets die ganze Funktion $M_T(z)$ zu betrachten. Das Wesentliche am in Fig. 3b beschriebenen Verfahren ist es nun, dass durch die Anwendung einer geeigneten Feldänderung $dB_T$ alle $M_T(z)$ den gleichen Wert, hier $+B_{T\,MAX}$ annehmen, also $M_T(z) \equiv +B_{T\,MAX}$.

Was für einen Einfluss hat nun die transversale Magnetisierung der supraleitenden Komponenten 8 bzw. 10 auf den Feldverlauf des statischen Magnetfeldes $B_0$ in der NMR Probe 7 ?

Dies ist in **Fig. 1a** und **1b** dargestellt. In beiden Zeichnungen sind jeweils links ein supraleitendes Element (hier mit 8 bezeichnet) der Empfangsspule dargestellt, zusammen mit seiner transversalen Magnetisierung $M_T$ (z), deren Verlauf als Funktion von z dargestellt ist. Zu beachten ist, dass die Magnetisierung sich nur innerhalb der beiden Maximalwerte $+ M_{T\,MAX}$ und $- M_{T\,MAX}$ befinden kann.

In der mittleren Darstellung sind die sich aus der Magnetisierung ergebenden Feldlinien des Störmagnetfeldes $B_M$ im Raum dargestellt. Von Interesse für die NMR Homogenität sind aber jeweils nur die Bz Komponenten, die sich innerhalb der Probe und gleichzeitig innerhalb des aktiven HF Bereichs befinden (dies wird in [6] hergeleitet). Dieser ist mit "RF" dargestellt.

Auf der rechten Seite findet sich schließlich die Darstellung der $B_z$ Komponente entlang des Probenmitte (z-Achse) als Funktion von z.

Nun zur Wirkungsweise des Verfahrens: In Fig. 1a sieht man, dass ein allgemeiner Verlauf 13' der transversalen Magnetisierung $M_T(z)$ zu einem stark gestörten Verlauf der durch die Magnetisierung erzeugten Störfelder $B_M$ wie auch deren z-Komponenten $B_{Mz}$ führt und somit zu einem gestörten Verlauf von $B_z$ und somit zu Störungen der Linienform des NMR Spektrums.

In Fig. 1b wurde das erfindungsgemäße Verfahren angewendet. Es führt keinesfalls zu einer Minimierung der Magnetisierung des Supraleiters selbst, sondern im einfachsten, hier dargestellten Fall, zu seiner Maximierung.

Dadurch werden auch die Störfelder $B_M$ in der Probe maximal groß. Dank der Tatsache aber, dass die Magnetisierung 13" entlang z weitestgehend konstant ist, ergibt sich gemäss [6] ein Feldverlauf der $B_z$ Komponenten, der zwar an den Enden der supraleitenden Strukturen (die z-Ausdehnung dieser ist mit "SC" gekennzeichnet) zu starken Störungen führt, aber innerhalb des kleineren HF Bereichs ("RF") zu einem praktisch verschwindenden Verlauf von $B_z$ führt. Somit ist es gelungen, mittels einer maximalen Magnetisierung die eigentliche NMR Störung, die nur von der $B_z$ Komponente herrührt (siehe ausführliche Abhandlung in [6]) praktisch zu eliminieren!

Bisher wurde nur ein einfachster Verlauf im Feld $B_T$, der zum Erreichen des gewünschten Effekts genügend ist, diskutiert. Es gibt jedoch eine weitere Anzahl von möglichen und sinnvollen Verläufen, sowie verschiedene mögliche Ausgangszustände. Diese Effekte sollen in der Folge etwas genauer diskutiert werden.

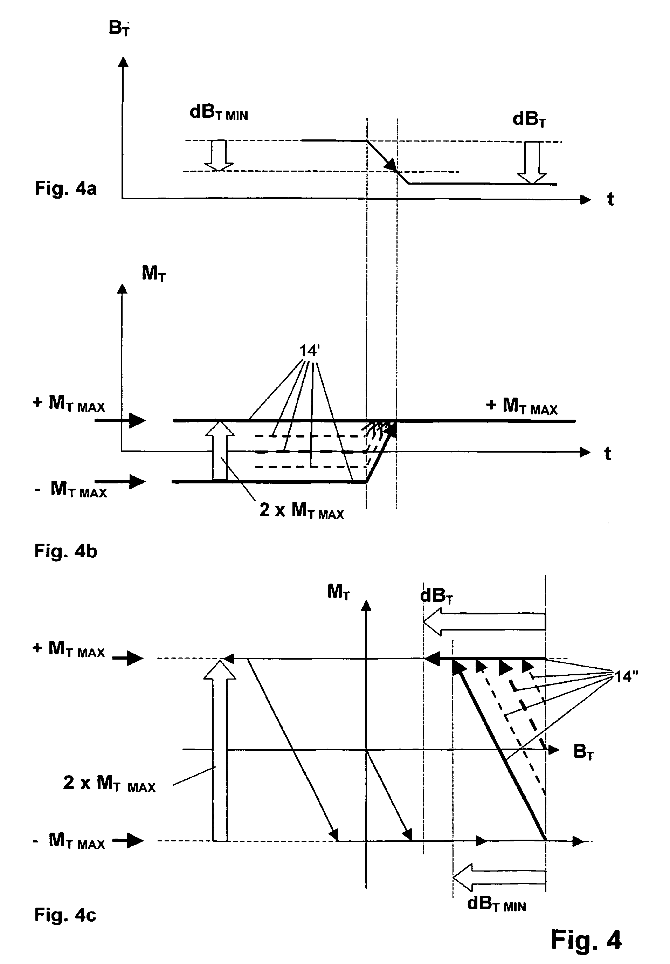

In **Fig. 4a** ist eine Änderung des äußeren Feldes $B_T$ als Funktion der Zeit angenommen. In **Fig. 4b** ist die zugehörige Reaktion $M_T$ eines supraleitenden Flächenelements ebenfalls als Funktion der Zeit dargestellt. In **Fig. 4c** ist schließlich die Beziehung zwischen $B_T$ und $M_T$ dargestellt.

Das Feld $B_T$ ändert insgesamt um $dB_T$. Dabei wird nun die Magnetisierung positiv und strebt, unabhängig vom Ausgangszustand, gegen den Maximalwert $+M_{T\,MAX}$. Übersteigt die Feldänderung den (im Wesentlichen vom Material gegebenen) minimal nötigen Wert $dB_{T\,MIN}$, so werden alle Flächenelemente maximal und, entsprechende Geometrie vorausgesetzt, somit gleichmäßig magnetisiert, unabhängig von ihrer ursprünglichen Magnetisierung.

Dies ist die Grundlage des Verfahrens. Damit wird die gewünschte homogene Magnetisierung prinzipiell erzeugt. In Fig. 4b und 4c wird deutlich, dass die gesamte Schar 14 aller möglichen Magnetisierungszustände (der Verlauf der Magnetisierungen als Funktion der Zeit wird mit 14', der Verlauf als Funktion des Feldes $B_T$ mit 14" bezeichnet, Extremwerte sind fett, Zwischenwerte gestrichelt dargestellt) in den Zustand einer eindeutig definierten, maximalen Magnetisierung $+M_{T\,MAX}$ überführt wird.. Die einzigen Voraussetzungen hierfür sind die entsprechende Geometrie der HF Spulen sowie die Anwendung einer transversalen Feldänderung $|dB_T| \geq dB_{T\,MIN}$. Dabei ist $dB_{T\,MIN}$ diejenige Feldänderung, die notwendig ist, um ein Supraleiterelement vollständig umzumagnetisieren. Dies entspricht im Extremfall der Umkehrung des (kritischen) Stromes oder auch der Änderung der Magnetisierung um $2*M_{T\,MAX}$.

Die einfachste prinzipielle Implementierung des Verfahren wird mit einer Feldspule durchgeführt. In **Fig. 5a** ist eine HF Spule 8 oder ein Abschnitt davon dargestellt. Daneben befindet sich eine Feldspule 21, die transversale Feldänderungen $dB_T$ durch Änderung $dI$ des in ihr fließenden Stromes $I$ erzeugen kann. In **Fig. 5b** ist die zeitliche Änderung $dI$ des Stromes $I$ dargestellt. Dies hat eine Änderung des transversalen äußeren Feldes um $dB_T$ zur Folge (**Fig. 5c**), und dies erzeugt eine vollständige transversale Magnetisierung $M_T$ innerhalb des ganzen Abschnittes (**Fig. 5d**), unabhängig vom Ausgangszustand und Verlauf 14'. Nach Ablauf des Verfahrens ist die gesamte transversale Magnetisierung $M_T = M_{T\,MAX}$.

Die Erzeugung des transversalen Feldes $B_T$ muss nicht zwingend durch eine Feldspule geschehen. Eine andere, sehr effektive Implementierung des Verfahrens ist sehr gut durchführbar: Bei dieser wird die transversale Komponente nicht direkt durch ein äußeres Feld erzeugt, sondern durch die Verkippung (**Fig. 6b**) der Spule oder einzelner Elemente 8 um den Winkel $d\alpha$ um eine Achse 19, die vorzugsweise senkrecht zum (sehr starken) äußeren Magnetfeld $B_0$ orientiert ist (**Fig. 6a**). Dadurch entsteht im Koordinatensystem des Supraleiters eine effektive Feldänderung $dB_{T\,eff}$ (**Fig. 6c**). Diese führt im Supraleiter zu den gleichen Effekten wie die zuvor besprochene Komponente $B_T$ (Fig. 6d).

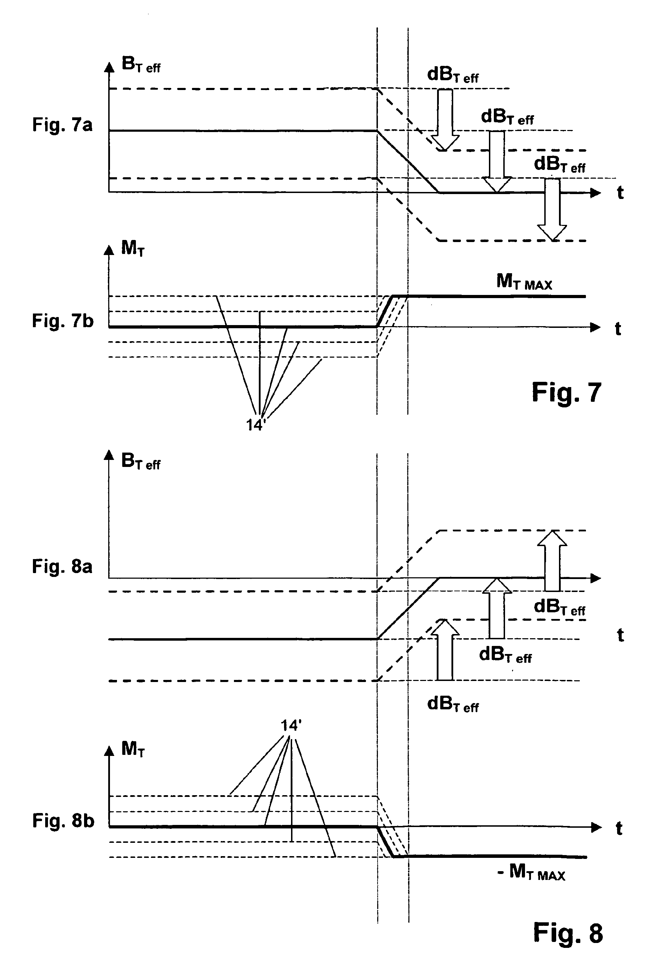

Unabhängig von der Art der Erzeugung der transversalen Komponente $B_T$ wollen wir hier die Auswirkungen auf $M_T$ untersuchen. Es ist nur die Änderung $dB_T$ wesentlich, aber nicht die absolute Größe von $B_T$. Alle in **Fig. 7a** dargestellten Verläufe (durchgezogen oder gestrichelt) von $B_T$ führen zum gleichen Verhalten betr. der Magnetisierung (**Fig. 7b**). Dies ist insofern von Wichtigkeit, dass keinerlei Bedingungen über den genauen Wert der transversalen Feldkomponente relevant sind.

Das Ziel der gleichmäßigen Magnetisierung ist erreicht, wenn alle Elemente entlang z die gleiche Magnetisierung aufweisen. Es kommt nicht darauf an, ob diese Magnetisierung positiv oder negativ ist. Alle drei Verläufe von $B_T(t)$ in **Fig. 8a** führen zur gleichen Endmagnetisierung $-M_{T\,MAX}$ (**Fig. 8b**). Für die praktische Anwendung ist hier wichtig, dass das Vorzeichen der angewandten effektiven Feldänderungen insgesamt oder auch zwischen den einzelnen Spulenelementen untereinander nicht relevant ist.

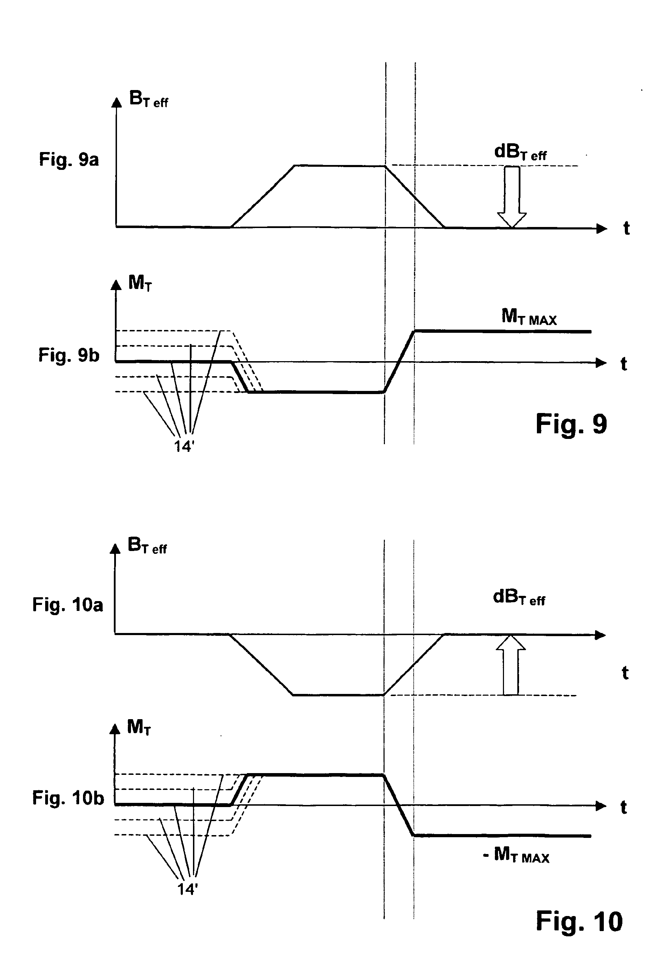

Aus technischen Gründen ist es vorteilhaft oder unter Umständen fast zwingend, dass der Anfangs- und Endzustand des Verfahrens identisch sind (Wiederholbarkeit). Bisher wurden nur Stufenfunktionen im $B_T$ diskutiert. Dies muss aber keineswegs so sein, es ist auch problemlos möglich einen Puls (mit einer positiven und einer negativen Flanke) anzuwenden. Die einzige Bedingung ist nur, dass die Amplitude $dB_{T\,eff}$ hinreichend groß ist (**Fig. 9a**). Wie in **Fig. 9b** leicht eingesehen werden kann, werden alle zu Beginn möglichen Magnetisierungszustände in den einzigen Magnetisierungszustand $M_{T\,MAX}$ überführt.

Bei der technischen Realisation braucht man sich nicht um die Vorzeichen zu kümmern, auch ein negativer Puls (**Fig. 10a**) führt zu einer zwar negativen, aber wiederum gleichmäßigen Magnetisierung (**Fig. 10b**).

Das Verfahren kann weiter verallgemeinert werden. Es funktioniert auch mit einem Doppelpuls beliebiger relativer Stärke, es genügt nur, wenn $dB_{Teff}$ hinreichend groß ist (**Fig. 11**).

Das Beispiel in **Fig. 12** demonstriert auch bei zwei Pulsen gleichen Vorzeichens die uneingeschränkte Effektivität des Verfahrens, wiederum unter der Voraussetzung, dass $dB_{Teff}$ hinreichend groß ist (**Fig. 12a**). Am Schluss sind Elemente mit einer beliebigen Anfangsmagnetisierung gleich magnetisiert (**Fig. 12b**).

Bisher wurden Beispiele von Pulssequenzen gezeigt, die alle mit der Feldänderung $dB_T$ endeten ($|dB_T| \geq dB_{T\,MIN}$). Dies war der "Sättigungspuls", der die Aufgabe hat, die Magnetisierung aller Elemente zu maximieren ("Sättigen"). In der Folge wollen wir diese Feldänderung nun gesondert mit "$dB_{T\,SAT}$" bezeichnen. Diesen am Ende der Magnetfeldsequenz anzuordnen ist zwar der einfachste und auch robusteste Fall, ist aber nicht zwingend. Es gibt weitere Sequenzen, die auch ohne diese Reihenfolge zum gewünschten Ziel führen:

Ein solcher Fall ist in **Fig. 13a** dargestellt. Die Sättigungsfeldänderung $dB_{T\,SAT}$ wird noch von einer zusätzlichen Feldänderung $dB_{T\,FIN}$ gefolgt. Diese ist im Vorzeichen entgegengesetzt zum $dB_{T\,SAT}$ (ansonsten sind sie in der Wirkung nicht unterscheidbar und die Behandlung dieses Falles erübrigt sich).

Die Anwendung von $dB_{T\,FIN}$ reduziert die Magnetisierung unter den maximalen Wert (**Fig. 13b**). In **Fig. 13c** ist der Zusammenhang in der $B_T$-$M_T$ Ebene dargestellt. Wichtig ist jedoch, dass auch die reduzierte Magnetisierung (bei entsprechender Auslegung der supraleitenden Spule und der Vorrichtung zum Erzeugen von $B_T$) auch wiederum (entlang z) konstant bleibt (auf einem Wert $M_{T\,FIN}$, unter $M_{T\,MAX}$) und zwar völlig unabhängig von der Anfangsmagnetisierung (verschiedene Anfangszustände von $M_T$ inklusive ihrer Entwicklung sind gestrichelt in Fig. 13b als Funktion der Zeit (14') und in Fig. 13c als Funktion von $B_T$ (14") dargestellt). Somit ist die Aufgabe immer noch erfüllt, eine konstante Magnetisierung aller Elemente entlang z zu erzielen. Es ist jedoch nur wichtig, dass die Werte der verschiedenen Elemente die entlang z liegen, untereinander gleich sind. Es ist aber nicht der Zweck oder Ziel dieses Verfahrens, den Wert $M_T = 0$ anzustreben.

Bei einer Anwendung gemäss **Fig. 14,** bei der aber der letzte Puls hinreichend groß ist, ist es auch möglich, das Vorzeichen von $M_T$ gegenüber dem gesättigtem Wert $M_{T\,MAX}$ umzukehren (Fig. 14b,c).

Bisher wurde das Verfahren nur abstrakt in Bezug auf die anzuwendenden Felder diskutiert. In der Folge wollen wir noch kurz auf die benötigte Hardware eingehen. Eine Übersicht eines Kryo-Probenkopfes, mit dem das erfindungsgemäße Verfahren durchgeführt werden kann, ist in **Fig 15** dargestellt:

Der Kryo-Probenkopf 15 weist supraleitende Empfangsspulen 8 auf. Diese werden mittels des Wärmetauschers 18 und Kühlleitungen 16, die normalerweise mit gasförmigem oder flüssigem He durchströmt werden, gekühlt. Die zu messende NMR Probe befindet sich in einer Öffnung des Probenkopfes, die sich normalerweise bei oder in der Nähe von Zimmertemperatur befindet und dort mittels des Temperiergases 17 auf der gewünschten Temperatur gehalten wird. Die Erzeugung der $B_T$ Komponenten kann unabhängig voneinander mittels zwei verschiedenen Vorrichtungen geschehen, die hier eingezeichnet sind: Einerseits eine direkte Erzeugung eines $B_x$ Feldes durch die Feldspulen 21, oder aber durch Verkippung der supraleitenden Spule(n) 8 um die Drehachse 19, wobei die Kippbewegung mit einem Aktuator 20 bewerkstelligt wird.

Bisher wurden die Verhältnisse diskutiert, die sich bei Spulen ergeben, die supraleitende Elemente parallel zu einer einzigen Ebene aufweisen (wie in Fig. 2a oder Fig. 15). Anordnungen, die eine allgemeinere Anordnung der Elemente aufweisen (wie die Anordnung der Spulen 8 in Fig. 16 oder die Elemente 10 in Fig. 2b), brauchen transversale Komponenten des $B_T$ Feldes senkrecht zu allen vorkommenden Ebenen, und zwar in einer hinreichend großen Stärke. Dies kann bewerkstelligt werden durch die Anwendung effektiver transversaler Felder in zwei verschiedenen Richtungen, wie in **Fig. 16** dargestellt. Dies kann implementiert werden mittels der Verwendung von zwei unabhängigen Aktuatoren 20, die Drehungen um die Achse 19' um die x-Richtung sowie um die Achse 19" um die y-Richtung erlauben. Keine der Achsen 19', 19" und z sind zueinander parallel, im Normalfall sind die senkrecht zueinander angeordnet. In der einfachsten Version wird zuerst um eine und dann um die andere Achse gekippt. Diese Bewegungen können in geeigneten Fällen aber auch gekoppelt werden, was einer Kippung um eine einzige, schräge Achse entspricht.

Die Erzeugung zweier Felder mit verschiedenen Richtungen kann aber auch durch eine entsprechende Anordnung von Feldspulen implementiert werden, wie in **Fig. 17** dargestellt wird: Im Probenkopf 15 sind zwei Spulenpaare 21' und 21" eingebaut, die transversale Felder in der x bzw. y-Richtung erzeugen können. Diese können entweder nacheinander oder gemeinsam angesteuert werden.

Das Verfahren ist aber in vielen Fällen ohne jegliche zusätzliche Vorrichtung durchführbar, wie im Folgenden gezeigt wird:

> **Fig. 18** zeigt den supraleitenden Magneten 1, der durch flüssiges Helium 6 gekühlt wird und sich in der He-Kanne 2 befindet. Diese ist durch Vakuum 5 thermisch vom Außenmantel 3 des Dewars isoliert. Das Raumtemperatur-Bore 4 nimmt den Probenkopf 15 (gemäss Fig. 15, 17) auf.

Wichtig ist hier der Verlauf des statischen Magnetfeldes $B_0$. Dieses bildet ein Vektorfeld $B_0(x,y,z)$, das normalerweise rotationssymmetrisch ist und daher als $B_0(z,r)$ beschrieben werden kann. Wesentlich ist nun der Verlauf dieses Feldes sowohl innerhalb wie auch außerhalb des Magnet- Raumtemperaturbores 4:

In einem engen Bereich um das Magnetzentrum "MC" befindet sich der während des Betriebs des Spektrometers verwendete, extrem homogene Bereich des Magnetfeldes. Der Verlauf der relevanten $B_z$ Komponente $B_z(z)$ ist entlang der z-Achse, die durch die Linie A-A' definiert wird, gesondert dargestellt. Wegen der Rotationssymmetrie um die z-Achse ist das Feld entlang der gesamten z-Achse streng in z-Richtung orientiert, es kommen also keinerlei transversalen Komponenten $B_T$ (in der Form von $B_r$ oder auch $B_x$, By) vor. Innerhalb des Magnets ist das homogene Gebiet sichtbar, wie auch der rasche Feldabfall gegen die Magnetenden hin, wie auch der asymptotisch abklingende Streufeldabfall außerhalb des Magneten.

Für das erfindungsgemäße Verfahren interessant ist jedoch der Feldverlauf außerhalb der z-Achse: Auf einer Linie B-B' im Abstand $r_0$ von der z-Achse ist die $B_z$ Komponente zwar ähnlich (hier nicht dargestellt) wie derjenige auf der z-Achse selbst. Wichtig ist jedoch aber, dass außerhalb der Achse transversale (d.h. radiale) Komponenten ($B_r$) des statischen Feldes vorkommen, und zwar in einer sehr wohl definierten Weise. Wegen div B = 0 lässt sich mittels des Gaussschen Satzes zeigen, dass jede Änderung von $B_z$ in der z-Richtung eine radiale Komponente $B_r$ des Feldes im Abstand $r_0$ von der z-Achse zwingend nach sich zieht. Es gilt in guter Näherung:

$$B_r(z, r_0) = -\frac{1}{2} r_0 \frac{dB_z(z, 0)}{dz}$$

Bei einem angenommenen Magnetfeld von 10T und einem steilsten Abfall dieses Feldes, der dem Abfall des gesamten Feldes über eine Strecke von 200 mm entsprechen soll, ergibt sich bei einem Abstand von $r_0 =$ 4mm von der Symmetrieachse eine maximale radiale Feldkomponente von $B_T$ aus $B_r$ = 1000 G. Dies ist i.A. ausreichend, um eine vollständige Magnetisierung der heutigen zum Aufbau der supraleitenden HF Spulen verwendeten Supraleiter durchzuführen.

Die $B_r$ Komponente entlang der Linie B-B' ist nun separat dargestellt. Sie weist in den beiden Bereichen, wo das $B_z$ Feld nach oben und unten hin am steilsten abfällt, jeweils ein relativ starkes Maximum des Betrags auf.

Dies wird nun für eine sehr einfache, aber wirkungsvolle Variante des erfindungsgemäßen Verfahrens benutzt, wie es in **Fig. 19** in Detail dargestellt wird: Die Arbeitsposition des Kryo-Probenkopfes im Magnetzentrum innerhalb des Magnetbores 4 ist mit 15 gekennzeichnet, zusammen mit den supraleitenden Elementen 8 des Empfangsspulensystems. Diese befinden sich im Abstand $r_0$ von der z-Achse. Eine zur z-Achse parallele Linie in diesem Abstand ist mit B-B' gekennzeichnet. Aus Fig. 18 übernommen und separat dargestellt ist der schematische Verlauf der radialen Feldkomponente $B_r(z)$. Diese entspricht nun im Wesentlichen der transversalen Feldkomponente $B_T$, die schon ausgiebig besprochen wurde. Die hier dargestellte Variante des erfindungsgemäßen Verfahrens besteht aus einem Einführen des bereits kalten und supraleitenden Spulensystems in den Magneten. Dies kann z.B. durch ein Einführen des gesamten Probenkopfes aus einer Position 15' außerhalb der Arbeitsposition 15 in diese geschehen. Wie wir sehen werden, ist das letzte Stück des Einführens von Relevanz, und die weitere Vorgeschichte ist bedeutungslos. Insbesondere kann der sich in der Arbeitsposition 15 befindende, bereits kalte Kopf aus der Arbeitsposition 15 in die Position 15' heraus- und dann wieder in die Arbeitsposition 15 zurück eingeführt werden.

Wir gehen nun davon aus, dass sich nun die supraleitenden Spulenelemente in der Position 8' befinden. Sie sollen zunächst eine willkürliche Magnetisierung 13' $M_T$ (z) aufweisen.

Was mit der Magnetisierung beim Einführen in die Arbeitsposition 15 geschieht, ist auf dem Plot $M_T(z)$ rechts dargestellt. Entsprechend dem Verlauf des transversalen Feldes $B_r(z)$ ergeben sich, analog zu Fig. 4 oder 9, Trajektorien 14''', denen die Magnetisierung beim Einführen folgt. Die anfängliche Magnetisierung 13' wird nun, unabhängig vom Anfangszustand, in die für alle Elemente identische, maximal negative Magnetisierung $-M_{T\ MAX}$ überführt. Dies gelingt stets, wenn die Änderung $dB_{T\ eff}$ hinreichend groß ist ( $\geq dB_{T\ MIN}$, siehe Fig. 4) und die supraleitende Spule aus einer entsprechend weit herausgezogenen Position eingeführt wird.

Durch dieses Verfahren wird auf eine sehr einfache und extrem wirkungsvolle und robuste Art die gewünschte Homogenisierung der transversalen Magnetisierung und somit eine Eliminierung der NMR Störungen gemäss dem Übergang von Fig. 1a zu Fig. 1b erzielt).

Dieses Verfahren ist insbesondere auch geeignet, Spulen mit Supraleiteranordnungen in mehreren nicht parallelen Ebenen zu konditionieren, wie in der Anordnung der Spulen 8 in Fig. 16 oder die Elemente 10 in Fig. 2b dargestellt. Alle supraleitende Elemente enthaltenden Ebenen stehen im wesentlichen senkrecht zum Radiusvektor $r_0$ und erfahren somit alle gleichzeitig eine sehr effektive Magnetisierung.

<u>Zusammenstellung der Bezeichnungen:</u>

| | |
|---|---|
| 1 | Supraleitender Magnet |
| 2 | He - Kanne |
| 3 | Magnetdewar (Außenmantel) |
| 4 | RT Bore |
| 5 | Magnetvakuum |
| 6 | LHe zur Kühlung des Magneten |

7       Probe
8       Supraleitende HF-Empfangsspule
8'      Supraleitende HF-Empfangsspule ausserhalb der Arbeitsposition
9       Normalleitende Abschirmung der Hybrid-Birdcage Spule
10      Supraleitendes Element der Hybrid-Birdcage Spule
11      Z-Streifen als gedanklicher Ausschnitt aus der SL-Spule
12      Supraleitendes Element der HF Spule
13      Transversale Magnetisierung allgemein
13'     Transversale Magnetisierung ungeordnet
13"     Transversale Magnetisierung gesättigt
14      Trajektorien der Magnetisierung allgemein
14'     Trajektorien der Magnetisierung als Funktion von t
14"     Trajektorien der Magnetisierung als Funktion von $B_T$
14'''   Trajektorien der Magnetisierung als Funktion von z
15      Kryo-Probenkopf
15'     Kryo-Probenkopf außerhalb der Arbeitsposition
16      Kühlleitungen
17      N2 VT Gas
18      Kühl-Wärmetauscher für Empfangsspule
19      Drehachse allgemein
19'     Drehachse um x-Achse
19"     Drehachse um y-Achse
20      Aktuator
21      Feldspulen zur Magnetisierung allgemein
21'     Feldspulen zur Magnetisierung in x-Richtung
21"     Feldspulen zur Magnetisierung in y-Richtung

Referenzen:

[1]     US 5,619,140
[2]     WO 99/24845
[3]     WO 99/24821
[4]     US 5,572,127
[5]     DE 197 33 574 A1
[6]     DE 101 50 131.5-33 (noch nicht veröffentlicht)

**Patentansprüche**

1.  Verfahren zur Beseitigung von Störungen des homogenen statischen Magnetfeldes $B_0$ in Richtung einer z-Achse in einer Kernspinresonanz (=NMR)-Apparatur, die durch supraleitende Komponenten von Hochfrequenz (=HF)-Spulen zum Empfang von NMR-Signalen einer Probe (7) in einem Messvolumen der NMR-Apparatur verursacht werden, wobei die supraleitenden Komponenten der HF-Spulen planare Elemente (8,10) sind, und wobei die Störungen die z-Komponente des $B_0$-Feldes im HF-aktiven Bereich der Probe (7) betreffen, **dadurch gekennzeichnet,** **dass** die supraleitenden Komponenten (8,10) der HF-Spulen den HF-aktiven Bereich der Probe (7) in einer Messposition in der NMR-Apparatur in z-Richtung übertragen, und **dass** die supraleitenden Komponenten (8,10) der HF-Spulen einem transversal zu den planaren Elementen (8,10) gerichteten Magnetfeld ausgesetzt werden, das so stark ist, dass im Verlauf der Anwendung dieses transversal zu den planaren Elementen (8,10) gerichteten Magnetfeldes die supraleitenden Komponenten der HF-Spulen senkrecht zu den planaren Elementen (8,10) maximal magnetisiert werden und dadurch ihre bezüglich $B_0$ transversale Magnetisierung (13, 13") senkrecht zu den planaren Elementen (8,10) in der Messposition, in welcher die planaren Elemente (8,10) parallel zur z-Achse ausgerichtet sind, einen entlang der z-Achse im wesentlichen konstanten, von Null verschiedenen Wert annimmt.

2.  Verfahren nach Anspruch 1, **dadurch gekennzeichnet, dass** das transversal zu den planaren Elementen (8,10) gerichtete Magnetfeld in seinem zeitlichen Verlauf so gewählt wird, dass die supraleitenden Komponenten auch nach Anwendung dieses Magnetfeldes maximal magnetisiert bleiben und dadurch das durch sie verursachte, bezüglich $B_0$ transversale Magnetfeld im Probenbereich maximiert wird.

3.  Verfahren nach einem der vorhergehenden Ansprüche, **dadurch gekennzeichnet, dass** das transversal zu den planaren Elementen (8,10) gerichtete Magnetfeld transversal zum statischen Magnetfeld $B_0$ angelegt wird.

4.  Verfahren nach einem der Ansprüche 1 bis 3, **dadurch gekennzeichnet, dass** das transversal zu den planaren Elementen (8,10) gerichtete Magnetfeld durch eine Feldspule (21) erzeugt wird.

5.  Verfahren nach einem der Ansprüche 1 bis 3, **dadurch gekennzeichnet, dass** das transversal zu den planaren Elementen (8,10) gerichtete Magnetfeld durch zwei oder mehrere Feldspulen (21', 21") für verschiedene Feldrichtungen erzeugt wird, die nacheinander so aktiviert werden, dass im Verlauf der Aktivierung die supraleitenden Komponenten (8,10) der HF-Spulen mindestens einmal maximal magnetisiert werden.

6.  Verfahren nach einem der Ansprüche 4 oder 5, **dadurch gekennzeichnet, dass** das transversal zu den planaren Elementen (8,10) gerichtete, zusätzliche Magnetfeld ein einzelner Impuls ist.

**7.** Verfahren nach einem der Ansprüche 4 oder 5, **dadurch gekennzeichnet, dass** das transversal zu den planaren Elementen (8,10) gerichtete, zusätzliche Magnetfeld ein Doppel- oder Mehrfachpuls ist, bei dem der letzte Puls eine solche Amplitude und ein solches Vorzeichen besitzt, dass die endgültige, bezüglich $B_0$ transversale Magnetisierung (13, 13") der supraleitenden Komponenten ungleich Null ist.

**8.** Verfahren nach Anspruch 7, **dadurch gekennzeichnet, dass** das transversal zu den planaren Elementen (8,10) gerichtete, zusätzliche Magnetfeld ein Doppelpuls ist, bei dem der zweite Puls das umgekehrte Vorzeichen des ersten Pulses hat und die Amplituden beider Pulse ungefähr gleich groß sind.

**9.** Verfahren nach einem der Ansprüche 1 oder 2, **dadurch gekennzeichnet, dass** das auf die supraleitenden Komponenten wirkende transversal zu den planaren Elementen (8,10) gerichtete, Magnetfeld durch eine Verkippung der planaren Elemente (8,10) um eine nicht zur Richtung von $B_0$ parallele Achse (19) erzeugt wird.

**10.** Verfahren nach einem der Ansprüche 1 oder 2, **dadurch gekennzeichnet, dass** das auf die supraleitenden Komponenten wirkende, transversal zu den planaren Elementen (8,10) gerichtete, Magnetfeld durch eine sukzessive Verkippung der planaren Elemente (8,10) um zwei Achsen (19', 19") erzeugt wird, die jeweils nicht zur Richtung von $B_0$ und auch nicht zueinander parallel sind.

**11.** Verfahren nach einem der Ansprüche 1 bis 3, **dadurch gekennzeichnet, dass** das transversal zu den planaren Elementen (8,10) gerichtete Magnetfeld durch ein erstmaliges oder abermaliges Einführen der bereits supraleitenden HF-Spulen in den Magneten (1), der das statische Magnetfeld $B_0$ erzeugt, erzeugt wird.

**12.** Verfahren nach einem der vorhergehenden Ansprüche 2-7 oder 9-11, **dadurch gekennzeichnet, dass** die Anwendung des transversal zu den planaren Elementen (8,10) gerichteten Magnetfelds mit nur einem Vorzeichen erfolgt.

**Claims**

**1.** Method for eliminating disturbances in the homogeneous static magnetic field $B_0$ in the direction of a z-axis in a nuclear magnetic resonance (NMR) apparatus, which are caused by superconducting components of radio frequency (RF) coils for receiving NMR signals of a sample (7) in a measuring volume of the NMR apparatus, wherein the superconducting components of the RF coils are planar elements (8, 10) and wherein the disturbances concern the z-component of the $B_0$ field in the RF-active region of the sample (7),
**characterized in that**
the superconducting components (8, 10) of the RF coils project in the z-direction past the RF-active region of the sample (7) in a measuring position in the NMR apparatus,
and that the superconducting components (8, 10) of the RF coils are exposed to a magnetic field which is arranged transversely with respect to the planar elements (8, 10) and is sufficiently strong for maximally magnetizing the superconducting components of the RF coils perpendicularly to the planar elements (8, 10) in the process of applying this magnetic field which is arranged transversely with respect to the planar elements (8, 10), and for this reason, in the measuring position in which the planar elements (8, 10) are arranged parallel to the z axis, magnetization (13, 13") of the superconducting components transverse with respect to $B_0$ and perpendicular to the planar elements (8, 10) assumes a value other than zero which is substantially constant along the z-axis.

**2.** Method according to claim 1, **characterized in that** the temporal dependence of the magnetic field which is arranged transversely with respect to the planar elements (8, 10) is selected such that the superconducting components also remain maximally magnetized after application of this magnetic field, thereby maximizing the magnetic field in the sample region, which is caused by the superconducting components and is transverse to $B_0$.

**3.** Method according to any one of the preceding claims, **characterized in that** the magnetic field which is arranged transversely with respect to the planar elements (8, 10) is applied transversely with respect to the static magnetic field $B_0$.

**4.** Method according to any one of the claims 1 to 3, **characterized in that** the magnetic field which is arranged transversely with respect to the planar elements (8, 10) is generated by a field coil (21).

**5.** Method according to any one of the claims 1 to 3, **characterized in that** the magnetic field which is arranged transversely with respect to the planar elements (8, 10) is generated by two or more field coils (21', 21") for different field directions, which are activated one after another such that during activation, the superconducting components (8, 10) of the RF coils are at least once maximally magnetized.

**6.** Method according to one of the claims 4 or 5, **characterized in that** the additional magnetic field which is arranged transversely with respect to the planar elements (8, 10) is one single pulse.

**7.** Method according to one of the claims 4 or 5, **characterized in that** the additional magnetic field which is arranged transversely with respect to the planar elements (8, 10) is a double or multiple pulse, the last pulse of which has an amplitude and sign such that the final magnetization (13, 13'), which is transverse to $B_0$, of the superconducting components is not zero.

**8.** Method according to claim 7, **characterized in that** the additional magnetic field which is arranged transversely with respect to the planar elements (8, 10) is a double pulse, wherein the second pulse is of opposite sign to that of the first pulse and the amplitudes of both pulses are approximately equal.

**9.** Method according to one of the claims 1 or 2, **characterized in that** the magnetic field which is arranged transversely with respect to the planar elements (8, 10) and acts on the superconducting components is generated through tilt of the planar elements (8, 10) about an axis (19) which is not parallel to the direction $B_0$.

**10.** Method according to one of the claims 1 or 2, **characterized in that** the magnetic field which acts on the superconducting components and is arranged transversely with respect to the planar elements (8, 10) is generated by successive tilting of the planar elements (8, 10) about two axes (19', 19") which are not parallel to the $B_0$ direction nor parallel to each other.

**11.** Method according to any one of the claims 1 to 3, **characterized in that** the magnetic field which is arranged transversely with respect to the planar elements (8, 10) is generated by first-time or repeated introduction of the RF coils, which are in the superconducting state, into the magnet (1) which generates the static magnetic field $B_0$.

**12.** Method according to any one of the preceding claims 2 to 7 or 9 to 11, **characterized in that** the magnetic field which is arranged transversely with respect to the planar elements (8, 10) is applied with only one sign.

**Revendications**

**1.** Procédé pour éliminer les perturbations du champ magnétique statique homogène $B_0$ en direction d'un axe z dans un appareil à résonance magnétique nucléaire (RMN), qui sont provoquées par des composants supraconducteurs de bobines à haute fréquence (HF) destinées à la réception des signaux RMN d'un échantillon (7) dans un volume de mesure de l'appareil RMN, les composants supraconducteurs des bobines HF étant des éléments planaires (8, 10) et les perturbations concernant la composante z du champ $B_0$ dans la zone active HF de l'échantillon (7),

**caractérisé en ce**
**que** les composants supraconducteurs (8, 10) des bobines HF dépassent en direction z la zone active HF de l'échantillon (7) placé dans une position de mesure dans l'appareil RMN,
et **que** les composants supraconducteurs (8, 10) des bobines HF sont exposés à un champ magnétique dirigé transversalement aux éléments planaires (8, 10) qui est assez puissant pour que, au cours de l'application de ce champ magnétique dirigé transversalement aux éléments planaires (8, 10), les composants supraconducteurs des bobines HF soient magnétisés au maximum perpendiculairement aux éléments planaires (8, 10) et que, de ce fait, leur magnétisation transversale par rapport à $B_0$ (13, 13") prend, perpendiculairement aux éléments planaires (8, 10), dans la position de mesure dans laquelle les éléments planaires (8, 10) sont orientés parallèlement à l'axe z, une valeur essentiellement constante, différente de zéro le long de l'axe z.

**2.** Procédé selon la revendication 1, **caractérisé en ce que** la variation dans le temps du champ magnétique dirigé transversalement aux éléments planaires (8, 10) est choisie de façon que les composants supraconducteurs restent magnétisés au maximum même après application de ce champ magnétique et que, de ce fait, le champ magnétique transversal par rapport à $B_0$ provoqué par eux soit maximalisé dans la région de l'échantillon.

**3.** Procédé selon une des revendications précédentes, **caractérisé en ce que** le champ magnétique dirigé transversalement aux éléments planaires (8, 10) est appliqué transversalement au champ magnétique statique $B_0$.

**4.** Procédé selon une des revendications 1 à 3, **caractérisé en ce que** le champ magnétique dirigé transversalement aux éléments planaires (8, 10) est produit par une bobine de champ (21).

**5.** Procédé selon une des revendications 1 à 3, **caractérisé en ce que** le champ magnétique dirigé transversalement aux éléments planaires (8, 10) est produit par deux ou plusieurs bobines de champ (21', 21") pour différentes directions de champ qui sont activées l'une après l'autre de façon qu'au cours de l'activation les composants supraconducteurs (8, 10) des bobines HF soient, au moins une fois, magnétisés au maximum.

**6.** Procédé selon une des revendications 4 ou 5, **caractérisé en ce que** le champ magnétique supplémentaire dirigé transversalement aux éléments planaires (8, 10) est une impulsion unique.

7. Procédé selon une des revendications 4 ou 5, **caractérisé en ce que** le champ magnétique supplémentaire dirigé transversalement aux éléments planaires (8, 10) est une impulsion double ou multiple dans laquelle la dernière impulsion possède une telle amplitude et un tel signe que la magnétisation définitive, transversale par rapport à $B_0$ (13, 13") des composants supraconducteurs est différente de zéro.

8. Procédé selon la revendication 7, **caractérisé en ce que** le champ magnétique supplémentaire dirigé transversalement aux éléments planaires (8, 10) est une impulsion double dans laquelle la deuxième impulsion est de signe inverse à celui la première impulsion et les amplitudes des deux impulsions sont approximativement égales.

9. Procédé selon une des revendications 1 ou 2, **caractérisé en ce que** le champ magnétique agissant sur les composants supraconducteurs, dirigé transversalement aux éléments planaires (8, 10), est produit par un basculement des éléments planaires (8, 10) autour d'un axe (19) non parallèle à la direction de $B_0$.

10. Procédé selon une des revendications 1 ou 2, **caractérisé en ce que** le champ magnétique agissant sur les composants supraconducteurs, dirigé transversalement aux éléments planaires (8, 10), est produit par un basculement successif des éléments planaires (8, 10) autour de deux axes (19', 19") non parallèles à la direction de $B_0$ et non parallèles l'un à l'autre.

11. Procédé selon une des revendications 1 à 3, **caractérisé en ce que** le champ magnétique dirigé transversalement aux éléments planaires (8, 10) est produit par une première ou une nouvelle introduction des bobines HF déjà supraconductrices dans l'aimant (1) qui produit le champ magnétique statique $B_0$.

12. Procédé selon une des revendications précédentes 2 à 7 ou 9 à 11, **caractérisé en ce que** l'application du champ magnétique dirigé transversalement aux éléments planaires (8, 10) a lieu avec seulement un signe.

$\pm M_{T\,MAX}$

$M_T(z)$

13'

8

7

$B_M$

$B_{M\,z}(z)$

RF

$B_{M\,z}$

**Fig. 1a**

$\pm M_{T\,MAX}$

13"

$M_T(z)$
= const.

8

7

$B_M$

$B_{M\,z}(z)$

RF

SC

$B_{M\,z}$

**Fig. 1b**

**Fig. 2a**

**Fig. 2b**

**Fig. 3a**

**Fig. 3b**

**Fig. 3**

Fig. 4a

Fig. 4b

Fig. 4c

Fig. 4

Fig. 5a

Fig. 5b

Fig. 5c

Fig. 5d

Fig. 5

$d\alpha$

$B_0$

13

$\alpha$

$d\alpha$

$M_T$

19

$dB_{T\,eff}$

8

$B_M(t)$

**Fig. 6a**

$\alpha$

$d\alpha$

**Fig. 6b**

t

$B_{T\,eff}$

$dB_{T\,eff}$

**Fig. 6c**

t

14'

$M_T$

$M_{T\,MAX}$

**Fig. 6d**

t

**Fig. 6**

Fig. 7a

**Fig. 7**

Fig. 7b

Fig. 8a

Fig. 8b

**Fig. 8**

Fig. 9a

$B_{T\,eff}$

$dB_{T\,eff}$

t

Fig. 9b

$M_T$

$M_{T\,MAX}$

t

14'

## Fig. 9

Fig. 10a

$B_{T\,eff}$

$dB_{T\,eff}$

t

Fig. 10b

$M_T$

t

14'

$-M_{T\,MAX}$

## Fig. 10

Fig. 11a

Fig. 11b

Fig. 11

Fig. 12a

Fig. 12b

Fig. 12

$B_{T\,eff}$

$dB_{T\,SAT}$

$dB_{T\,FIN}$

t

**Fig. 13a**

$M_T$

$M_{T\,MAX}$ $M_{T\,FIN}$

t

**Fig. 13b**

14'

$M_T$

$dB_{T\,FIN}$

+ $M_{T\,MAX}$

14''

+ $M_{T\,FIN}$

$B_T$

- $M_{T\,MAX}$

$dB_{T\,SAT}$

**Fig. 13c**

**Fig. 13**

Fig. 14a

Fig. 14b

Fig. 14c

Fig. 14

**Fig. 15**

Fig. 16

**Fig. 17**

**Fig. 18**

**Fig. 19**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9924845 A
- US 5619140 A
- WO 9924821 A
- US 5572127 A
- DE 19733574 A1
- DE 10150131533